# EUROPEAN PATENT APPLICATION

(11) **EP 4 779 508 A1**
(43) Date of publication of application: **22.07.2026**
(21) Application number: 24865030.1
(22) Date of filing: 21.06.2024
(51) Int. Cl.: G06F 30/23, G01M 7/08, G06F 30/15

(54) **SIMULATION MODEL ACCURACY IMPROVEMENT SYSTEM, SIMULATION MODEL ACCURACY IMPROVEMENT METHOD, AND SIMULATION MODEL ACCURACY IMPROVEMENT PROGRAM**

(30) Priority: 14.09.2023 JP 2023149408; 28.12.2023 JP 2023222860
(71) Applicant: Jsol Corporation, Tokyo 102-0074 (JP)
(72) Inventor: OKAMURA, Masahiro, Tokyo 1020074 (JP)
(74) Representative: Müller-Boré & Partner Patentanwälte PartG mbB
(86) International application number: PCT/JP2024/022557
(87) International publication number: WO 2025/057523

(57) **Abstract**

A system readily identifies the specific locations and parameters causing discrepancies between test results and simulation results. The system is provided with a test result data input section for entering crash test data from physical objects, a simulation section for performing crash simulations, a mode-decomposition section that decomposes the shape and behavior data and a set of simulation curves generated by the simulation section, a coefficient calculation unit that calculates coefficients for fitting the simulation curve sets to the test result curve sets, a reconstruction unit that reconstructs the simulation curve sets and reconstructs virtual shape and behavior data, and a force output unit that calculates the force required to correct errors. between the shape and behavior data and the virtual shape and behavior data.

## Description

### TECHNICAL FIELD

This invention relates to a simulation model accuracy-improvement support system, a simulation model accuracy-improvement support method, and a simulation model accuracy-improvement support program.

### BACKGROUND

In the automobile industry, crash safety is extremely important, and currently crash safety is verified through full-scale vehicle tests. The definition of "safety" in full-scale vehicle tests is that under specified velocities and angles, with a specified crash test dummy, the accelerations and forces on the dummy remain below certain thresholds. However, in the real world, velocities, angles, and occupant body types vary widely, and there is a movement to change the definition of "safety" to one that considers these real-world conditions.

Conducting multiple physical tests would significantly increase cost. Therefore, to realize a "safety" defined above, it is necessary to utilize simulation, which in automobile development has reached a level at which highly accurate predictions are possible.

However, even if simulation is considered to have reached a level capable of highly accurate prediction, there still exist discrepancies from actual test results. Thus, to define safety corresponding to real-world conditions as mentioned above, it is necessary to indicate how reliable the simulation results are.

One scheme for comparing test results and simulation results is ISO 18571 (formerly CORA). In ISO 18571, the simulation result curves are quantified and evaluated from perspectives such as whether they fall within a corridor represented by two curves, whether the shapes of the test curve and the simulation result curve are similar, whether there is no phase shift, or whether the amplitude and slope matches, etc. In addition, the injury level of an occupant dummy is evaluated using injury values calculated from multiple curves.

### PRIOR ART DOCUMENT

### NON-PATENT DOCUMENT

Non-Patent Document 1: TECHNICAL SPECIFICATION ISO/TS 18571, First edition 2014-08-01, Road vehicles - Objective rating metric for non-ambiguous signals.

Furthermore, in the evaluation process of EuroNCAP (a European consumer organization), it is planned to evaluate the reliability of simulation results using a numerical value representing the agreement of each of numerous curves, based on ISO 18571. For automobile manufacturers, obtaining a score above a certain threshold in this evaluation is becoming extremely important.

### SUMMARY OF INVENTION

### PROBLEMS TO BE SOLVED BY THE INVENTION

However, identifying the locations or parameters that cause the discrepancy between test results and simulation results has been a very difficult task, and in practice the only option was repeated trial and error.

The present invention is intended to solve the above problems and aims to provide a simulation model accuracy-improvement support system, a simulation model accuracy-improvement support method, and a simulation model accuracy-improvement support program that can easily identify the locations and parameters causing discrepancies between test results and simulation results and simulation model accuracy while utilizing past test and simulation result data.

### MEANS TO SOLVE PROBLEMS

To address the aforementioned issues, in a first aspect of the simulation model accuracy-improvement support system of the present invention, the system comprises:
a test result data input unit configured to input test result data obtained from a crash test involving a physical object such as a vehicle;
a simulation unit configured to perform, using CAE analysis software based on a finite element method, a simulation of the crash test for a virtual object corresponding to the physical object;
a mode-decomposition unit configured to perform mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
a coefficient calculation unit configured to compare the set of simulation curves with a set of test result curves included in the test result data, the set of test result curves representing changes at predetermined locations of the physical object obtained from the crash test including acceleration outputs or displacement outputs, and to calculate coefficients for fitting the set of simulation curves to the set of test result curves;
a reconstruction unit configured to reconstruct the set of simulation curves based on the calculated coefficients and to reconstruct virtual shape and behavior data predicted to have occurred in the crash test based on the calculated coefficients; and
a force output unit configured to compare the shape and behavior data generated by the simulation unit with the reconstructed shape and behavior data reconstructed by the reconstruction unit and to calculate or estimate forces required to correct differences between them.

According to the first aspect of the simulation model accuracy-improvement support system of the present invention, coefficients are calculated for fitting the simulation curve group to the test result curve group. Based on the calculated coefficients, the simulation curve group is reconstructed. Furthermore, based on the calculated coefficients, virtual shape and behavior data expected to have occurred in the crash test are reconstructed.

Additionally, the shape and behavior data are compared with the virtual shape and behavior data, and the force required to correct the difference is calculated or estimated.

Consequently, it is possible to easily identify the locations and parameters causing the discrepancy between the test results and the simulation results, thereby providing a simulation model accuracy-improvement support system capable of enhancing the accuracy of the simulation model.

In another aspect of the simulation model accuracy-improvement support system of the present invention, the system comprises a correlation calculation unit that calculates a correlation between the mode-decomposed simulation curve group and shape and behavior data, and parameters of the virtual object including sheet metal thickness and the like.

According to this aspect, mode-decomposition is performed on the shape and behavior data and the simulation curve group, and the correlation between the mode-decomposed simulation curve group and the parameters of the virtual object is calculated.

Therefore, the relationship between the main behavior modes and the input parameters that influence them can be easily understood.

For example, differences in results in intuitive terms such as the behavior of a head part can be quantified for evaluation and study.

In a second aspect of the simulation model accuracy-improvement support system of the present invention, the system, comprises:
a test result data input unit configured to input test result data obtained from a crash test involving a physical object such as a vehicle;
a simulation unit configured to perform, using CAE analysis software based on a finite element method, a simulation of the crash test for a virtual object corresponding to the physical object;
a mode-decomposition unit configured to perform mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
a difference-pattern vector extraction unit configured to compare the set of simulation curves with a set of test result curves included in the test result data, the set of test result curves representing changes at predetermined locations of the physical object obtained from crash tests including acceleration outputs or displacement outputs, and extract a difference-pattern vector;
a coefficient calculation unit configured to compare the set of simulation curves with a set of test result curves, and to calculate coefficients for fitting the set of simulation curves to the set of test result curves;
a reconstruction unit configured to reconstruct the set of simulation curves based on the calculated coefficients and to reconstruct virtual shape and behavior data predicted to have occurred in the crash test based on the calculated coefficients;
a force output unit configured to compare the shape and behavior data generated by the simulation unit with the reconstructed shape and behavior data reconstructed by the reconstruction unit and to calculate or estimate forces required to correct differences between them;
a knowledge database unit configured to store data including past test results, past simulation results, past proposal reports, and information regarding differences between past test results and simulations;
a similarity determination unit configured to determine similarity regarding differences between the current test result and the simulation based on the test result data, the shape and behavior data generated by the simulation unit, the reconstructed shape and behavior data reconstructed by the reconstruction unit, or data from the knowledge database unit; and
a recommendation proposal unit configured to extract, based on an output of the similarity determination unit, countermeasures corresponding to cases having high similarity regarding differences between the current test result and the simulation from the data in the knowledge database and to propose how parameters of the virtual object including sheet metal thickness should be changed in order to improve a predetermined evaluation score.

According to a second aspect of the simulation model accuracy-improvement support system of the present invention, in addition to the first aspect described above, a similarity regarding the discrepancy between the current test results and the simulation is determined based on test result data, shape and behavior data created by the simulation unit, shape and behavior data reconstructed by the reconstruction unit, or data from the knowledge database unit.

Furthermore, for cases where the similarity between the current test results and the simulation is high, countermeasures are extracted based on data from the knowledge database unit.

The system then proposes how to modify the parameters to increase a predetermined evaluation score.

Consequently, specific proposals are made to bring the simulation results closer to the test results.

This enables users to easily resolve issues and provides a simulation model accuracy-improvement support system capable of enhancing the accuracy of the simulation model.

In another aspect of the simulation model accuracy-improvement support system of the present invention, the system comprises,
a discrepancy-visualization unit is configured, based on the shape and behavior data created by the simulation unit and the shape and behavior data reconstructed by the reconstruction unit, to vectorize information of a nodal coordinate group in mode space of a given component in the shape and behavior data, and to calculate a distance or direction in the mode space by performing mode-decomposition on the vector, thereby visualizing the degree of discrepancy of the shape and behavior of the given component from the direction of the difference-pattern vector at a given timing, based on whether mode coordinate values are close or not,
wherein the recommendation proposal unit is configured, based on output from at least one of the similarity determination unit and the discrepancy-visualization unit, to extract from the data of the knowledge database, a countermeasure for a case having a high similarity in differences between the current test result and simulation result, and proposes how the parameters should be changed in order to improve a predetermined evaluation score.

According to this aspect, in addition to the second aspect, the nodal coordinate groups of the predetermined member in the mode space within the shape and behavior data are vectorized, and the distance or direction in the mode space is calculated by decomposing the vector into modes.

The deviation degree of the behavior of the predetermined member is visualized based on whether the mode coordinate values are close at a predetermined timing.

Furthermore, based on the output from at least one of the similarity judgment units and the deviation visualization unit, countermeasures for cases with high similarity regarding the difference between the current test results and the simulation are extracted based on data from the knowledge database.

Proposals are then made on how to modify the parameters to increase the predetermined evaluation score.

Therefore, since specific proposals are made to bring the simulation results closer to the test results, the user can more easily solve problems, enabling the provision of a simulation model accuracy-improvement support system that can enhance the accuracy of the simulation model.

In another aspect of the simulation model accuracy-improvement support system of the present invention, the similarity determination unit comprises:
a discrepancy-pattern similarity determination unit configured to determine similarity of curve discrepancy-patterns based on the difference pattern vector; and
a deformation-mode similarity determination unit configured to vectorize, based on the shape and behavior data generated by the simulation unit and the shape and behavior data reconstructed by the reconstruction unit, information of nodal coordinate groups in a mode space of the shape and behavior data, and to calculate a distance or direction in the mode space by decomposing the vector into modes, and to determine similarity of deformation-modes based on whether mode coordinate values are close at a predetermined timing,
wherein the recommendation proposal unit is configured to extract, based on outputs of at least one of the discrepancy-pattern similarity determination unit, the deformation-mode similarity determination unit, and a discrepancy-visualization unit, countermeasures corresponding to cases having high similarity regarding differences between a current test result and a simulation from data stored in the knowledge database, and proposes how the parameters should be changed in order to improve a predetermined evaluation score.

According to this aspect, in addition to the other aspects, a difference-pattern vector between the group of test result curves and the group of simulation curves is extracted, and based on the difference-pattern vector, the similarity of the deviation patterns of the curves is determined.

Furthermore, the information of the nodal coordinate groups in the mode space within the shape and behavior data is vectorized, and by decomposing this vector into modes, the distance or direction in the mode space is calculated.

The similarity of the deformation-modes is judged based on whether the mode coordinate values are close at a predetermined timing.

Furthermore, based on the output from at least one of the deviation pattern similarity determination unit, the deformation-mode similarity determination unit, and the deviation degree visualization unit, countermeasures for cases with high similarity regarding the difference between the current test results and the simulation are extracted based on data from the knowledge database.

A proposal is made on how to change the parameters to increase a predetermined evaluation score.

Therefore, the user can learn specific measures to bring the simulation results closer to the test results based on the similarity of the curve deviation patterns, or based on the similarity of the deformation-modes, or based on the output of the deviation visualization unit, or based on at least one of these.

This facilitates problem solving and provides a simulation model accuracy-improvement support system capable of enhancing the accuracy of the simulation model.

In another aspect of the simulation model accuracy-improvement support system of the present invention, the system comprises a correlation calculation unit that calculates a correlation between the mode-decomposed simulation curve group and shape and behavior data, and parameters of the virtual object including sheet metal thickness and the like.

In this other aspect, the shape and behavior data and the simulation curves undergo mode-decomposition, and the correlation between the mode-decomposed simulation curves and shape and behavior data and the parameters of the virtual object is calculated.

Therefore, the relationship between the main behavior modes and the input parameters affecting them can be easily understood.

For example, differences in results expressed intuitively, such as head behavior, can be quantified for evaluation and consideration.

In another aspect of the simulation model accuracy-improvement support system of the present invention, the system further comprises an automatic execution unit that automatically executes the countermeasure proposed by the recommendation proposal unit.

In this other aspect, the user can more easily identify the locations and parameters causing discrepancies between test results and simulation results, and can improve the accuracy of the simulation model while utilizing past test and simulation result data.

To address the aforementioned issues, in a first aspect of the simulation model accuracy-improvement support method of the present invention, the method comprises the steps of:
inputting test result data obtained from a crash test involving a physical object such as a vehicle by a test result data input unit;
performing, by a simulation unit, a simulation of the crash test for a virtual object corresponding to the physical object using CAE analysis software based on a finite element method;
performing mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
comparing, by a coefficient calculation unit, the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing, by a reconstruction unit, the set of simulation curves based on the calculated coefficients, and reconstructing virtual shape and behavior data predicted to have occurred in the crash test based on the calculated coefficients; and
comparing, by a force output unit, the shape and behavior data generated by the simulation unit with the reconstructed shape and behavior data reconstructed by the reconstruction unit, and calculating or estimating forces required to correct differences between them.

In the first aspect of the present invention's simulation model accuracy-improvement support method, coefficients for fitting the simulation curve group to the test result curve group are calculated.

The simulation curve group based on the calculated coefficients is reconstructed.

Virtual shape and behavior data predicted to have occurred in the crash test based on the calculated coefficients is reconstructed.

Further, the shape and behavior data is compared with the virtual shape and behavior data.

The force required to correct the difference is calculated or estimated.

Consequently, this method facilitates the identification of locations and parameters causing discrepancies between test and simulation results, thereby providing a simulation model accuracy-improvement support method capable of enhancing simulation model precision.

In another aspect of the simulation model accuracy-improvement support method of the present invention, the method comprises a step of calculating, by a correlation calculation unit, a correlation between the mode-decomposed simulation curve group and shape and behavior data, and parameters of the virtual object including sheet metal thickness and the like.

According to this other aspect, the shape and behavior data and the simulation curve group undergo mode-decomposition, and the correlation between the mode-decomposed simulation curve group and shape and behavior data and the parameters of the virtual object is calculated.

Therefore, the relationship between the main behavior modes and the input parameters affecting them can be easily understood.

For example, differences in results expressed intuitively, such as head behavior, can be quantified for evaluation and consideration.

To address the aforementioned issues, a second aspect of the simulation model accuracy-improvement support method of the present invention comprises the steps of:
inputting test result data obtained from a crash test involving a physical object such as a vehicle by a test result data input unit;
performing, by a simulation unit, a simulation of the crash test for a virtual object corresponding to the physical object using CAE analysis software based on a finite element method;
performing mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
comparing, by a difference-pattern vector extraction unit, the set of simulation curves with a set of test result curves included in the test result data, the set of test result curves representing changes at predetermined locations of the physical object obtained from crash tests including acceleration outputs or displacement outputs, and extracting a difference-pattern vector;
comparing, by a coefficient calculation unit, the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing, by a reconstruction unit, the set of simulation curves based on the calculated coefficients, and reconstructing virtual shape and behavior data predicted to have occurred in the crash test based on the calculated coefficients;
comparing, by a force output unit, the shape and behavior data generated by the simulation unit with the reconstructed shape and behavior data reconstructed by the reconstruction unit, and calculating or estimating forces required to correct differences between them;
determining, by a similarity determination unit, similarity regarding differences between the current test result and the simulation based on the test result data, the shape and behavior data generated by the simulation unit, the reconstructed shape and behavior data reconstructed by the reconstruction unit, or data obtained from a knowledge database unit storing data including past test results, past simulation results, past proposal reports, and information regarding differences between past test results and simulations; and
extracting, by a recommendation proposal unit, based on an output of the similarity determination unit, countermeasures corresponding to cases having high similarity regarding differences between the current test result and the simulation from the data stored in the knowledge database unit, and proposing how parameters of the virtual object including sheet metal thickness should be changed in order to improve a predetermined evaluation score.

In a second aspect of the simulation model accuracy-improvement support method of the present invention, in addition to the first aspect described above, the similarity regarding the discrepancy between the current test results and the simulation is determined based on test result data, shape and behavior data created by the simulation unit, shape and behavior data reconstructed by the reconstruction unit, or data from the knowledge database unit.

Furthermore, for cases where the similarity between the current test results and the simulation is high, countermeasures are extracted based on data from the knowledge database unit.

This proposes how to modify the parameters of the virtual object, including sheet metal thickness, to increase a predetermined evaluation score.

Therefore, specific proposals are made to bring the simulation results closer to the test results.

This enables users to easily solve problems and provides a simulation model accuracy-improvement support method capable of enhancing the accuracy of the simulation model.

In another aspect of the simulation model accuracy-improvement support method of the present invention, the method comprises a step of
vectorizing, by a discrepancy-visualization unit, based on the shape and behavior data created by the simulation unit and the shape and behavior data reconstructed by the reconstruction unit, information of a nodal coordinate group in mode space of a given component in the shape and behavior data, and calculating a distance or direction in the mode space by performing mode-decomposition on the vector, thereby visualizing the degree of discrepancy of the shape and behavior of the given component from the direction of the difference-pattern vector at a given timing, based on whether mode coordinate values are close or not,
wherein the step of proposing extracts, based on an output of at least one of the similarity determination unit and the discrepancy-visualization unit, from the data of the knowledge database, a countermeasure for a case having a high similarity in differences between the current test result and simulation, and proposes how the parameters should be changed in order to improve a predetermined evaluation score.

According to this aspect, in addition to the second aspect, the nodal coordinate groups of the predetermined member in the mode space within the shape and behavior data are vectorized, and the distance or direction in the mode space is calculated by decomposing the vector into modes.

The deviation degree of the behavior of the predetermined member is visualized based on whether the mode coordinate values are close at a predetermined timing.

Furthermore, based on the output from at least one of the similarity determination unit and the deviation visualization unit, countermeasures for cases with high similarity regarding the difference between the current test results and the simulation are extracted based on the data in the knowledge database unit.

Proposals are then made on how to modify the parameters to increase the predetermined evaluation score.

Therefore, since specific proposals are made to bring the simulation results closer to the test results, the user can more easily solve problems, enabling the provision of a simulation model accuracy-improvement support system that can enhance the accuracy of the simulation model.

In another aspect of the simulation model accuracy-improvement support method of the present invention, the step of determining the similarity comprises the steps of:
determining, by a discrepancy-pattern similarity determination unit included in the similarity determination unit, similarity of curve discrepancy-patterns based on the difference-pattern vector; and
vectorizing, by a deformation-mode similarity determination unit included in the similarity determination unit, based on the shape and behavior data generated by the simulation unit and the shape and behavior data reconstructed by the reconstruction unit, information of nodal coordinate groups in a mode space of the shape and behavior data, and calculating a distance or direction in the mode space by decomposing the vector into modes, and determining similarity of deformation-modes based on whether mode coordinate values are close at a predetermined timing,
wherein the step of proposing extracts, based on outputs of at least one of the discrepancy-pattern similarity determination unit, the deformation-mode similarity determination unit, and the discrepancy-visualization unit, from data of the knowledge database, a countermeasure for a case having high a similarity regarding differences between the current test result and simulation and proposes how the parameters should be changed in order to improve a predetermined evaluation score.

According to this aspect, in addition to the other aspects, a deviation pattern vector is extracted from the group of test result curves and the group of simulation curves.

The similarity of the deviation patterns of the curves is judged based on the deviation pattern vector.

Furthermore, the nodal coordinate groups in the mode space of the behavior data are vectorized.

By decomposing this vector into modes, the distance or direction in the mode space is calculated.

The similarity of the deformation-modes is determined based on whether the mode coordinate values are close at a predetermined timing.

Furthermore, based on the output from at least one of the deviation pattern similarity determination unit, the deformation-mode similarity determination unit, and the deviation degree visualization unit, countermeasures for cases with high similarity regarding the difference between the current test results and the simulation are extracted based on data from the knowledge database.

A proposal is made on how to change the parameters to increase a predetermined evaluation score.

Therefore, the user can learn specific measures to bring the simulation results closer to the test results based on the similarity of the curve deviation patterns, or based on the similarity of the deformation-modes, or based on the output of the deviation visualization unit, or based on at least one of these.

This facilitates problem solving and provides a simulation model accuracy-improvement support method capable of enhancing the accuracy of the simulation model.

In another aspect of the simulation model accuracy-improvement support method of the present invention, the method comprises a step of calculating, by a correlation calculation unit, a correlation between the mode-decomposed simulation curve group and shape and behavior data, and parameters of the virtual object including sheet metal thickness and the like.

In this other aspect, the shape and behavior data and the simulation curve group undergo mode-decomposition, and the correlation between the mode-decomposed simulation curve group and shape and behavior data and the parameters of the virtual object is calculated.

Therefore, the relationship between the main behavior modes and the input parameters affecting them can be easily understood.

For example, differences in results expressed intuitively, such as head behavior, can be quantified for evaluation and consideration.

In another aspect of the simulation model accuracy-improvement support method of the present invention, the method further comprises a step of automatically executing, by an automatic execution unit, the countermeasure proposed by the recommendation proposal unit.

In this other aspect, the user can more easily identify the locations and parameters causing the discrepancy between the test results and the simulation results and can improve the accuracy of the simulation model while utilizing past test results and simulation results data.

To address the aforementioned issues, in a first aspect of the simulation model accuracy-improvement support program of the present invention is a simulation model accuracy-improvement support program, a computer program for supporting simulation model accuracy-improvement, the computer program causes a computer to perform the steps of:
inputting test result data obtained from a crash test involving a physical object such as a vehicle;
performing a simulation of the crash test for a virtual object corresponding to the physical object using CAE analysis software based on a finite element method;
performing mode-decomposition on shape and behavior data and a set of simulation curves generated by the step of simulation, that is, the shape and behavior data representing the shape and behavior of the virtual object and the set of simulation curves representing changes at predetermined locations of the virtual object including acceleration outputs or displacement outputs;
comparing the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing the set of simulation curves based on the calculated coefficients, and reconstructing virtual shape and behavior data predicted to have occurred in the crash test based on the calculated coefficients; and
comparing the shape and behavior data generated by the simulation with the reconstructed shape and behavior data reconstructed, and calculating or estimating forces required to correct differences between them.

In the first aspect of the simulation model accuracy-improvement support program of the present invention, coefficients for fitting the simulation curve group to the test result curve group are calculated.

The simulation curve group based on the calculated coefficients is reconstructed.

Virtual shape and behavior data predicted to have occurred in the crash test based on the calculated coefficients is reconstructed.

Further, the shape and behavior data with the virtual shape and behavior data is compared, and the force required to correct the difference is calculated or estimated.

Consequently, it can readily identify the locations and parameters causing the discrepancy between the test results and the simulation results, thereby providing a simulation model accuracy-improvement support program capable of enhancing the accuracy of the simulation model.

In another aspect of the simulation model accuracy-improvement support program of the present invention, the program causes the computer to perform a step of calculating a correlation between the mode-decomposed simulation curve group and shape and behavior data, and parameters of the virtual object including sheet metal thickness and the like.

According to another aspect, mode-decomposition is performed on the shape and behavior data and the simulation curve group, and the correlation between the mode-decomposed simulation curve group and shape and behavior data and the parameters of the virtual object are calculated.

Therefore, the relationship between the main behavior modes and the input parameters affecting them can be easily understood.

For example, differences in results expressed intuitively, such as head behavior, can be quantified for evaluation and consideration.

To address the aforementioned issues, in a second aspect of the simulation model accuracy-improvement support program of the present invention, the program causes a computer to perform the steps of:
inputting test result data obtained from a crash test involving a physical object such as a vehicle;
performing a simulation of the crash test for a virtual object corresponding to the physical object using CAE analysis software based on a finite element method;
performing mode-decomposition on shape and behavior data and a set of simulation curves, that is, the shape and behavior data representing the shape and behavior of the virtual object and the set of simulation curves representing changes at predetermined locations of the virtual object including acceleration outputs or displacement outputs;
comparing the set of simulation curves with a set of test result curves included in the test result data, the set of test result curves representing changes at predetermined locations of the physical object obtained from crash tests including acceleration outputs or displacement outputs, and extracting a difference-pattern vector;
comparing the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing the set of simulation curves based on the calculated coefficients, and reconstructing virtual shape and behavior data predicted to have occurred in the crash test based on the calculated coefficients;
comparing the shape and behavior data generated by the step of performing the simulation with the reconstructed shape and behavior data reconstructed, and calculating or estimating forces required to correct differences between them;
determining similarity regarding differences between the current test result and the simulation based on the test result data, the shape and behavior data generated by the step of performing the simulation, the reconstructed shape and behavior data reconstructed by the step of reconstructing, or data obtained from a knowledge database storing data including past test results, past simulation results, past proposal reports, and information regarding differences between past test results and simulations; and
extracting, based on an output of the step of determining the similarity, countermeasures corresponding to cases having high similarity regarding differences between the current test result and the simulation from the data stored in the knowledge database, and proposing how parameters of the virtual object including sheet metal thickness should be changed in order to improve a predetermined evaluation score.

In the second aspect of the simulation model accuracy-improvement support program of the present invention, in addition to the first aspect described above, the similarity regarding the discrepancy between the current test results and the simulation based on test result data, shape and behavior data created by the simulation step, shape and behavior data reconstructed by the reconstruction step, or data from the knowledge database section, is determined.

Then countermeasures for cases with high similarity regarding the discrepancy between the current test results and the simulation, is extracted based on data from the knowledge database section.

It is proposed how to modify the parameters of the virtual object, including sheet metal thickness, to increase a predetermined evaluation score.

Therefore, since specific proposals are made to bring the simulation results closer to the test results, the user can more easily solve problems.

This provides a simulation model accuracy-improvement support program capable of enhancing the accuracy of the simulation model.

In another aspect of the simulation model accuracy-improvement support program of the present invention, the program causes the computer to perform a step of vectorizing, based on the shape and behavior data created by the step of performing the simulation and the shape and behavior data reconstructed by the step of reconstructing, information of a nodal coordinate group in mode space of a given component in the shape and behavior data, and calculating a distance or direction in the mode space by performing mode-decomposition on the vector, thereby visualizing the degree of discrepancy of the shape and behavior of the given component from the direction of the difference-pattern vector at a given timing, based on whether mode coordinate values are close or not,
as the step of proposing, extracting, based on an output of at least one of the step of determining the similarity and the step of visualizing the degree of discrepancy, from the data of the knowledge database, a countermeasure for a case having a high similarity in differences between the current test result and simulation result, and proposing how the parameters should be changed in order to improve a predetermined evaluation score.

According to this aspect, in addition to the second aspect, the nodal coordinate groups of a predetermined member in the mode space within the shape and behavior data are vectorized.

By decomposing this vector into modes, the distance or direction in the mode space is calculated.

The deviation degree of the behavior of the predetermined member is visualized based on whether the mode coordinate values are close at a predetermined timing.

Furthermore, based on the output from at least one of the similarity judgment units and the deviation visualization unit, countermeasures for cases with high similarity regarding the difference between the current test results and the simulation are extracted based on the data in the knowledge database unit.

Proposals are then made on how to modify the parameters to increase the predetermined evaluation score.

Therefore, since specific proposals are made to bring the simulation results closer to the test results, the user can easily solve problems, enabling the provision of a simulation model accuracy-improvement support program that can enhance the accuracy of the simulation model.

In another aspect of the simulation model accuracy-improvement support program of the present invention, the program causes the computer to perform a step of:
as the step of determining the similarity, determining similarity of curve discrepancy-patterns based on the difference-pattern vector; and
vectorizing, based on the shape and behavior data generated by the step of performing the simulation and the shape and behavior data reconstructed by the step of reconstructing, information of nodal coordinate groups in a mode space of the shape and behavior data, and
calculating a distance or direction in the mode space by decomposing the vector into modes, and determining similarity of deformation-modes based on whether mode coordinate values are close at a predetermined timing,
as the step of proposing, extracting, based on outputs of at least one of the step of determining similarity of the discrepancy-pattern, the step of determining the similarity of the deformation-mode, and the step of visualizing the degree of the discrepancy, from the data of the knowledge database, a countermeasure for a case having a high similarity regarding differences between the current test result and simulation, and proposing how the parameters should be changed in order to improve a predetermined evaluation score.

According to this aspect, in addition to the other aspects, a difference-pattern vector is extracted between the test result curve group and the simulation curve group.

The similarity of the deviation patterns of the curves is judged based on the difference-pattern vector.

Furthermore, the information of the nodal coordinate groups in the mode space from the shape and behavior data is vectorized, and the distance or direction in the mode space is calculated by performing mode-decomposition on the vector.

The similarity of the deformation-modes is determined based on whether the mode coordinate values are close at a predetermined timing.

Furthermore, based on the output from at least one of the deviation pattern similarity determination units, the deformation-mode similarity determination unit, and the deviation degree visualization unit, countermeasures for cases with high similarity regarding the difference between the current test results and the simulation are extracted based on data from the knowledge database.

A proposal is made on how to change the parameters to increase a predetermined evaluation score.

Therefore, the user can learn specific measures to bring the simulation results closer to the test results based on the similarity of the curve deviation patterns, or based on the similarity of the deformation-modes, or based on either of them.

This facilitates problem solving and enables the provision of a simulation model accuracy-improvement support program that can enhance the accuracy of the simulation model.

In another aspect of the simulation model accuracy-improvement support program of the present invention, the program causes the computer to perform a step of calculating a correlation between the mode-decomposed simulation curve group and shape and behavior data, and parameters of the virtual object including sheet metal thickness and the like.

In this other aspect, the shape and behavior data and the simulation curve group undergo mode-decomposition, and the correlation between the mode-decomposed simulation curve group and shape and behavior data and the parameters of the virtual object is calculated.

Therefore, the relationship between the main behavior modes and the input parameters affecting them can be easily understood.

For example, differences in results expressed intuitively, such as head behavior, can be quantified for evaluation and consideration.

In another aspect of the simulation model accuracy-improvement support program of the present invention, the program causes the computer to perform a step of automatically executing the countermeasure proposed by the step of proposing.

In this other aspect, the user can more easily identify the locations and parameters causing the discrepancy between the test results and the simulation results and can improve the accuracy of the simulation model while utilizing data from past test results and simulation results.

### EFECT OF THE INVENTION

According to the present invention, it is possible to provide a simulation model accuracy-improvement support system, a simulation model accuracy-improvement support method, and a simulation model accuracy-improvement support program that make it possible to easily identify the locations or parameters causing the discrepancy between test results and simulation results, and to improve the accuracy of the simulation model while utilizing past test and simulation result data.

### BRIEF DESCRIPTION OF DRAWINGS

FIG. 1 is a diagram showing a schematic configuration of a simulation model accuracy-improvement support system according to a first embodiment of the present invention.
FIG. 2 is a diagram showing functional blocks of the simulation model accuracy-improvement support system of the first embodiment.
FIG. 3 is a diagram showing functional blocks of a database in the simulation model accuracy-improvement support system of the first embodiment.
FIG. 4 is a block diagram showing a processing flow in the simulation model accuracy-improvement support system of the first embodiment.
FIGS. 5(A) and 5(B) are diagrams showing results of principal component analysis by DIFFCRASH on a group of nodes of a head part at 100ms.
FIG. 6 is a diagram showing the behavior of each of two large clusters in first-mode coordinates.
FIGS. 7(A) and 7(B) are diagrams showing a correlation matrix between input parameters and mode contribution ratios.
FIG. 8 is a diagram showing results of regression analysis of input parameters and mode coordinates.
FIG. 9 is a diagram for explaining a mode-decomposition process in the simulation model accuracy-improvement support system of the first embodiment.
FIG. 10 is a diagram for explaining processing of the reconstruction unit in the simulation model accuracy-improvement support system of the first embodiment.
FIG. 11 is a diagram for explaining processing of the discrepancy-visualization unit in the simulation model accuracy-improvement support system of the first embodiment.
FIG. 12 is a block diagram showing a processing flow of extracting countermeasures in a case having a high similarity in differences between the current test result and simulation result in the simulation model accuracy-improvement support system of the first embodiment.
FIG. 13 is a diagram for explaining processing of the discrepancy-pattern similarity determination unit in the simulation model accuracy-improvement support system of the first embodiment.
FIG. 14 is a diagram for explaining processing of the deformation-mode similarity determination unit in the simulation model accuracy-improvement support system of the first embodiment.
FIG. 15 is a diagram for explaining processing of the deformation-mode similarity determination unit in the simulation model accuracy-improvement support system of the first embodiment.
FIG. 16 is a block diagram showing a processing flow of extracting countermeasures in a case having a high similarity in differences between the current test result and simulation result in the simulation model accuracy-improvement support system of a second embodiment of the present invention.

### DESCRIPTION OF EMBODIMENT

### (First Embodiment)

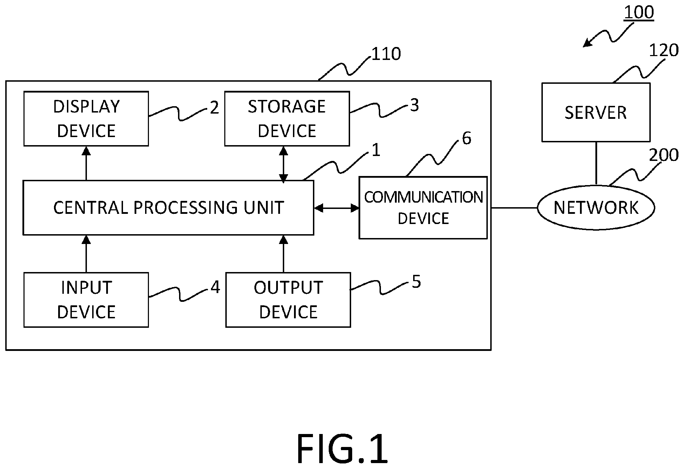

Hereinafter, a simulation model accuracy-improvement support system according to a first embodiment of the present invention will be described in detail with reference to the drawings. FIG. 1 is a diagram showing the schematic configuration of a simulation model accuracy-improvement support system 100 according to the present embodiment. As shown in FIG. 1, the simulation model accuracy-improvement support system 100 of this embodiment comprises a simulation model accuracy-improvement support device 110 and a server 120 connected to the simulation model accuracy-improvement support device 110 via a network 200 such as the Internet. As shown in FIG. 1, the simulation model accuracy-improvement support device 110 includes a central processing unit 1, a display device 2, a storage device 3, an input device 4, an output device 5, and a communication device 6.

The central processing unit 1 is a device capable of executing programs such as a personal computer, and includes a CPU and memory, etc. The display device 2 is a device capable of displaying text and images, such as an LCD (liquid crystal display). The storage device 3 is a device capable of storing programs and data, such as an HDD (Hard Disk Drive), and an external server or the like may be used. The program of the present invention is assumed to be stored in the storage device 3. The input device 4 is a device that allows user input of data or instructions, such as a keyboard. The output device 5 is a device capable of outputting text and images, such as a printer. In the simulation model accuracy-improvement support system 100 of the present embodiment, the output device 5 may be omitted. The communication device 6 is an interface that enables communication with the server 120 and other devices via the network 200.

The server 120 is used as a storage destination for metadata and simulation-result reports (described later). However, the present invention does not require the storage destination for metadata or reports to necessarily be a server. For example, local storage such as an HDD (Hard Disk Drive), a cloud server, or even a blockchain network may be used.

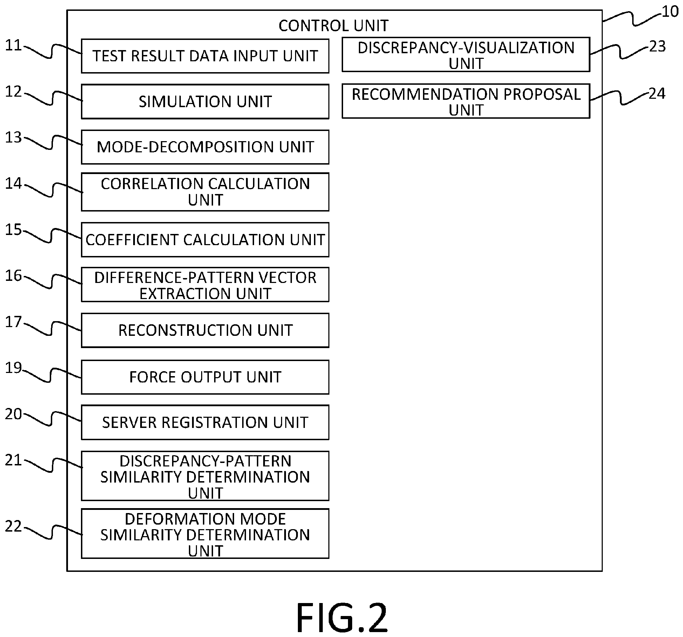

FIG. 2 is a diagram showing functional blocks that the central processing unit 1 of the simulation model accuracy-improvement support device 110 realizes by executing the program of the present invention. As shown in FIG. 2, the central processing unit 1 functions as a control unit 10. In accordance with the program of the present invention, the control unit 10 functions as a test result data input unit 11, a simulation unit 12, a mode-decomposition unit 13, a correlation calculation unit 14, a coefficient calculation unit 15, a difference-pattern vector extraction unit 16, a reconstruction unit 17, a force output unit 19, a server registration unit 20, a discrepancy-pattern similarity determination unit 21, a deformation-mode similarity determination unit 22, a discrepancy-visualization unit 23, and a recommendation proposal unit 24.

In the present embodiment, the program of the present invention is executable on the simulation model accuracy-improvement support device 110.

The test result data input unit 11, in the simulation model accuracy-improvement support device 110, inputs test result data from a crash test of a vehicle as the physical object for instance.

The simulation unit 12, using CAE analysis software based on the finite element method, performs a simulation of the crash test for a virtual object corresponding to the physical object. In the present embodiment, Ansys LS-DYNA (trademark) is used as an example of the CAE analysis software. In this simulation, shape and behavior data representing the shape and behavior of the virtual object, and a set of simulation curves representing changes at predetermined locations of the virtual object (including acceleration outputs or displacement outputs at those locations) are created. The shape and behavior data can also be visualized, for example, as a 3D animation-for the user's review. The visualization of the shape and behavior data can be performed at any time as selected by the user.

The mode-decomposition unit 13 performs mode-decomposition on the shape and behavior data and the set of simulation curves created by the simulation unit 12.

Mode-decomposition is performed on the shape and behavior data and the set of simulation curves based on the following data:
- shape and behavior data and a set of simulation curves generated in a simulation conducted under the same conditions as a crash test (a crash test conducted under a predetermined velocity condition and angle condition is referred to as a "base test," and a simulation conducted under the same velocity condition and angle condition as the base test is referred to as a "base calculation," details of which will be described later);
- archived past shape and behavior data and archived past sets of simulation curves stored in a simulation database unit described later;
- shape and behavior data and a set of simulation curves generated in another base calculation corresponding to another base test conducted under velocity and angle conditions different from those of the base test; and
- optionally one or more variation-case simulations conducted under velocity and angle conditions different from those of the base test.

The details of the mode-decomposition being described later.

The correlation calculation unit 14 calculates the correlation between the set of mode-decomposed simulation curves and shape and behavior data, and parameters of the virtual object including sheet metal thickness and the like. Details of this correlation calculation will be described later.

The coefficient calculation unit 15 compares the set of test result curves, which is included in the test result data and represents changes at a predetermined location of the vehicle obtained by the crash test, with the set of simulation curves, which represents changes at the corresponding predetermined location in the simulation. The coefficient calculation unit 15 then calculates a coefficient by which the set of simulation curves fits the set of test result curves.

The difference-pattern vector extraction unit 16 compares the set of test result curves (included in the test result data and representing changes at a predetermined location of the vehicle obtained by the crash test) with the set of simulation curves and extracts a difference-pattern vector.

The reconstruction unit 17, based on the coefficients calculated as described above, reconstructs the set of simulation curves and reconstructs virtual simulation results (shape and behavior data) that are predicted to have occurred in the crash test.

The force output unit 19 compares the shape and behavior data with the virtual shape and behavior data and calculates the force necessary to correct errors.

The server registration unit 20 stores, in a simulation database 121 and a knowledge database 122 (described later), data obtained by the simulation model accuracy-improvement support device 110, such as input test results, and data indicating countermeasures for correcting the discrepancies between test results and simulation results.

The discrepancy-pattern similarity determination unit 21 determines the similarity of curve discrepancy-patterns based on the difference-pattern vector.

The deformation-mode similarity determination unit 22, based on the shape and behavior data created by the simulation unit 12 and the shape and behavior data reconstructed by the reconstruction unit 17, vectorizes information of the set of nodal coordinates in mode space of the shape and behavior data, performs mode-decomposition on that vector, and calculates a distance in the mode space between simulation results. The deformation-mode-similarity determination unit 22 then determines the similarity of deformation-modes by checking whether the mode coordinate values are close at a given timing.

The discrepancy-visualization unit 23, based on the shape and behavior data created by the simulation unit 12 and the shape and behavior data reconstructed by the reconstruction unit 17, vectorizes information of the set of nodal coordinates in mode space of a given component of the shape and behavior data, performs mode-decomposition on that vector, calculates a distance in the mode space, and quantifies the degree of discrepancy. The discrepancy-visualization unit 23 may use not only distance but also directional information to quantify the discrepancy (because even with the same distance, different directions in the mode space yield different results). The discrepancy-visualization unit 23 determines, at a given timing, whether the mode coordinate values are close, and visualizes the degree of discrepancy in the behavior of the given component as a contour. Note that the method of visualizing the discrepancy is not limited to using contours. Methods of expressing discrepancy can include representing it as scalar or vector values. For example, a method may be adopted in which scalar values are indicated with a color bar (e.g., blue for low values and red for high values). It is also conceivable to present vector values using arrows.

The recommendation proposal unit 24, based on at least one output of the discrepancy-pattern similarity determination unit 21, the deformation-mode similarity determination unit 22, and the discrepancy-visualization unit 23, extracts from the knowledge database 122 data a countermeasure for a case having a high similarity in differences between the current test result and simulation result. The recommendation proposal unit 24 then proposes how to change the parameters to increase the predetermined evaluation score. The recommendation proposal unit 24 may also categorize the similarity of discrepancy-patterns determined by the discrepancy-pattern similarity determination unit 21. For example, a discrepancy-pattern is a numerical sequence created from the comparison between a test curve and a simulation curve at a given location. Possible categorizations include cases where a single curve's pattern is similar, or cases where the patterns of discrepancies at multiple locations are considered together and show similar tendencies. If patterns are similar or tendencies are similar in this way, it is conceivable that the deviations are caused by similar factors. Therefore, it is conceivable to make similar proposals for each such group. Furthermore, the recommendation proposal unit 24 does not need to use all outputs of the discrepancy-pattern similarity determination unit 21, the deformation-mode similarity determination unit 22, and the discrepancy-visualization unit 23 when making proposals. It may make proposals using at least one of the outputs of those units. In addition, when making proposals, certain constraints (such as available materials or shape layouts) may arise. In such cases, the recommendation proposal unit 24 can be configured to make proposals taking such constraints into account. Moreover, the recommendation proposal unit 24 may be configured to consider the correlation (calculated by the correlation calculation unit 14) between the set of simulation curves (and shape and behavior data) and the virtual object's parameters (including sheet metal thickness, etc.) when making the above proposals. Doing so can improve the persuasiveness and accuracy of the proposals.

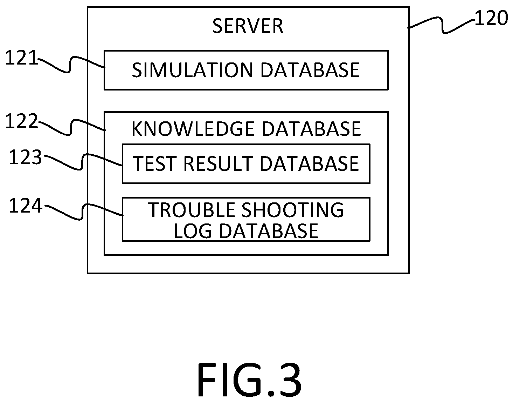

As shown in FIG. 3, server 120 is provided with the simulation database 121 and the knowledge database 122. The simulation database 121 is a database that stores past simulation results from the simulation unit 12.

The knowledge database 122 is a database that stores data including past test results, past simulation results, past proposal reports, and information on differences between past test results and simulations. The past data stored in the knowledge database 122 need not necessarily have been created by the user himself; it can include data from calculations or other work performed by third parties in the past.

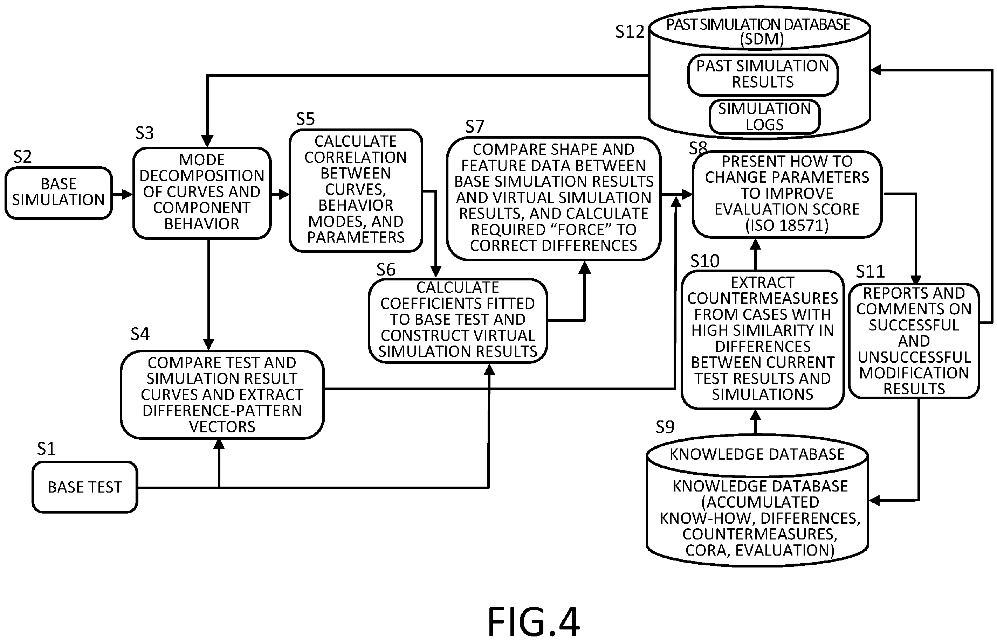

Next, an outline of the operation in this embodiment will be described with reference to FIG. 4 through FIG. 12. As shown in FIG. 4, in the present embodiment, the program of the present invention includes a comparison function between test results and simulation results, and a proposal function for countermeasures to correct discrepancies of the simulation results relative to the test results.

### <Comparison Function between Test results and Simulation Results>

First, the comparison function between test results and simulation results in the present embodiment will be described with reference to FIG. 4 through FIG. 12. In the present embodiment, a crash test is conducted in which a vehicle is crashed at a given velocity and angle, with a crash test dummy on board, and the accelerations and forces on the dummy are measured. As one example, a crash test conducted under certain velocity and angle conditions is referred to as the base test. In the present embodiment, the test result data input unit 11 inputs the data of the base test results (FIG. 4: S1).

Next, simulation unit 12 uses, for example, Ansys LS-DYNA (trademark) as CAE analysis software to create a finite element model (Finite Element Modeling: FEM) of a virtual object corresponding to the vehicle used in the base test. The simulation unit 12 then performs a finite element simulation corresponding to the crash test described above. As one example, a simulation conducted under the same velocity and angle conditions as the base test is referred to as the base calculation. The simulation unit 12 performs the base calculation (FIG. 4: S2).

As a result of the above simulation, shape and behavior data representing the behavior of the virtual object and a set of simulation curves representing changes at predetermined locations of the virtual object (including acceleration outputs or displacement outputs at those locations) are generated as the simulation results.

The mode-decomposition unit 13 performs mode-decomposition on the shape and behavior data and the set of simulation curves created by the simulation unit 12 (FIG. 4: S3). The mode-decomposition is performed based on the shape and behavior data and set of simulation curves from the base calculation, as well as past shape and behavior data and past sets of simulation curves stored in the simulation database 121. Alternatively, the mode-decomposition may also be performed based on shape and behavior data and sets of simulation curves created in another base calculation corresponding to another base test conducted under different velocity and angle conditions than the base test described above. Furthermore, the mode-decomposition may be performed based on one or multiple variation-case simulations conducted under different velocity and angle conditions than the base test, as described above, and the results of those simulations.

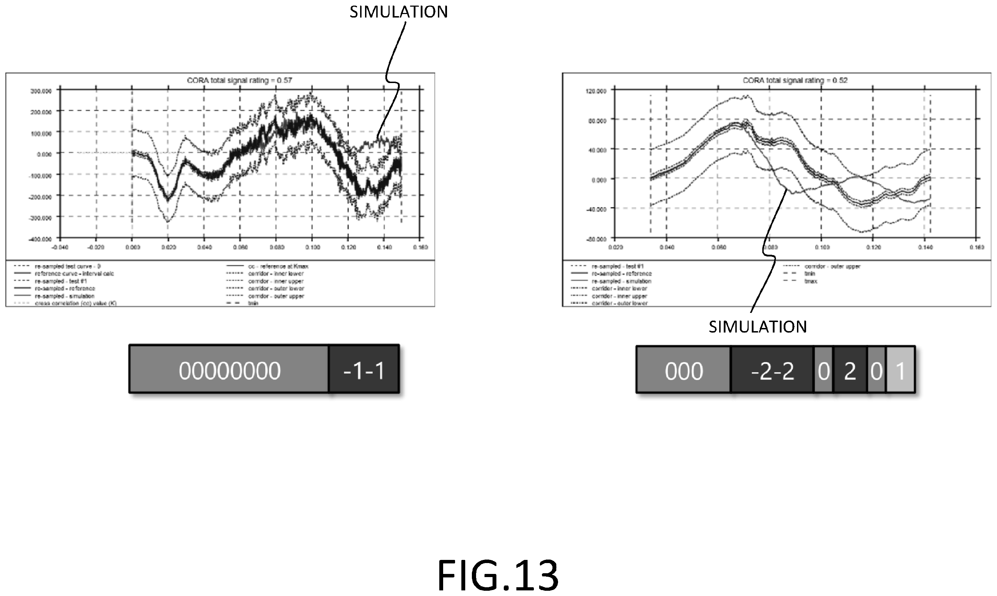

Next, the difference-pattern vector extraction unit 16 compares the set of test result curves (included in the base test's test result data and representing changes at predetermined locations of the vehicle obtained by the crash test) with the set of simulation curves obtained by the base calculation and extracts a difference-pattern vector (FIG. 4: S4). Note that extracting a difference-pattern vector serves to lower the resolution and make it easier to find similar patterns, because the curves have very complex shapes. For example, one may divide a 150ms duration event into 30ms segments, integrate the difference between curves over each segment, and then divide by the 30ms interval to average it. As shown in FIG. 13 (described later), the curves are extremely complex in shape, so the intent is to reduce the resolution and express them as numerical sequences. This is an example of a "difference-pattern vector."

Next, the correlation calculation unit 14 calculates the correlation between the set of simulation curves and shape and behavior data (mode-decomposed in step S4 by the mode-decomposition unit 13) and the parameters of the virtual object (including sheet metal thickness, etc.) (FIG. 4: S5).

This correlation calculation in the present embodiment is performed using, DIFFCRASH, a software developed by SIDACT GmbH in Germany, as an example. DIFFCRASH visualizes the degree of scatter (variability) from multiple calculation results of finite element solvers such as Ansys LS-DYNA (trademark), based on statistical methods (Reference for DIFFCRASH (1): R. Brown, M. Bloomfield, C. Thole, L. Nikitina, "Analysis of the Scatter of a Deploying Airbag," 12th International LS-DYNA Users Conference, 2012; Reference for DIFFCRASH (2): D. Borsotto et al., "Improving robustness of Chevrolet Silverado with exemplary design adaptations based on identified scatter sources," 10th European LS-DYNA Conference, 2015).

By using DIFFCRASH, the following can be achieved:
- Detection of major events and noteworthy locations.
- Dimensionality reduction of behavior at the time of event occurrence via mode-decomposition.
- Connection of input variables, intermediate variables (behavior modes), and output variables in chronological order to visualize relationships.

Below, a specific example (an Out-of-Position example for a vehicle occupant) will be described. In this example, the friction between the airbag and the dummy, and the position of the dummy, are used as parameters.

(STEP 1) First, based on the shape and behavior data, the extraction of major events and points of interest is performed. For example, the behavior of the dummy's head is taken as a major event and a point of interest.

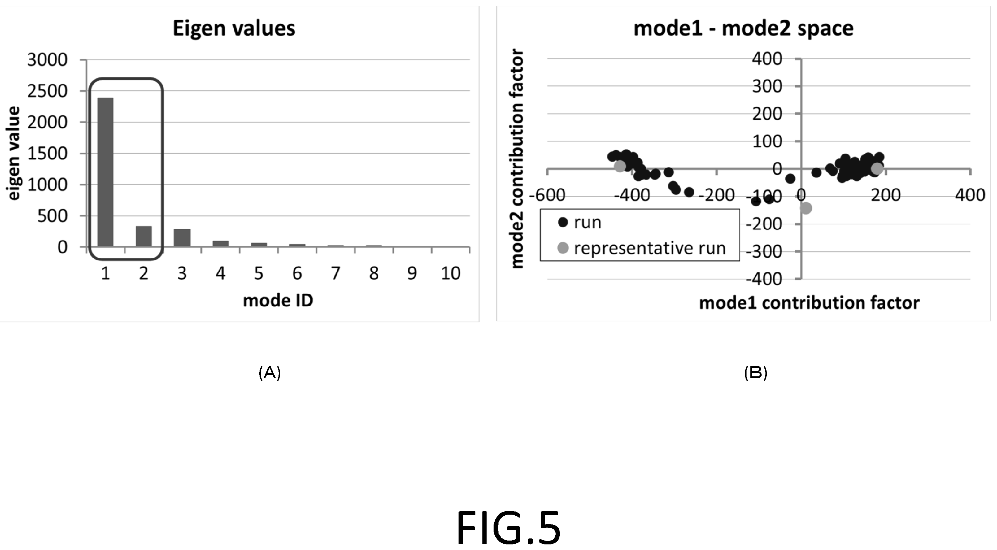

(STEP 2) Next, a principal component analysis is performed on the behavior of crash dummy at 100ms (final state), which is the major event. Through this process, each calculation result is dimensionally reduced to a 2D or 3D position vector. FIGS. 5(A) and 5(B) show the results of principal component analysis by DIFFCRASH on the group of nodes of the head part at 100ms.

From the eigenvalue ranking in FIG. 5(A), it can be seen in this example that the first mode is dominant compared to the second and subsequent modes. The points in FIG. 5(B) each represent one simulation result. The coordinates on the first and second mode axes in each result indicate the contribution ratios expressing that behavior as a superposition of modes. From FIG. 5 (B) in this example two large clusters are observed on the left and right of the first-mode axis, indicating that there is a bifurcation in behavior.

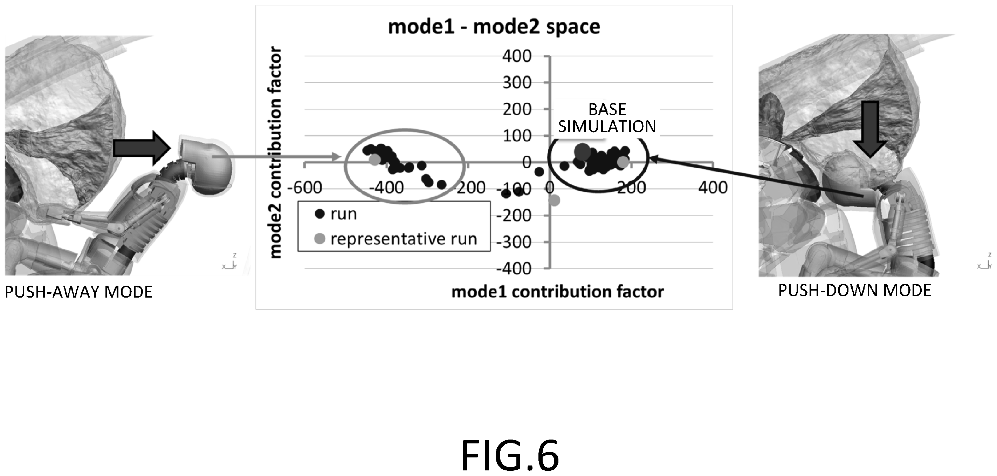

FIG. 6 shows the behavior in each of the clusters. The cluster on the negative side of the first-mode axis is a mode in which the dummy is thrust forward by the airbag ("push-out mode"), and the cluster on the positive side is a mode in which the dummy's head is pushed downward by the airbag ("push-down mode").

(STEP 3) Next, a regression analysis is performed regarding the input parameters and the modes. Variations in parameters influence the behavior of key parts in each event. This appears as mode contribution ratios in the graph, and by performing regression analysis, it becomes possible to evaluate which parameter had the greatest influence on the behavior. First, the relationship between input parameters and mode contribution ratios was analyzed.

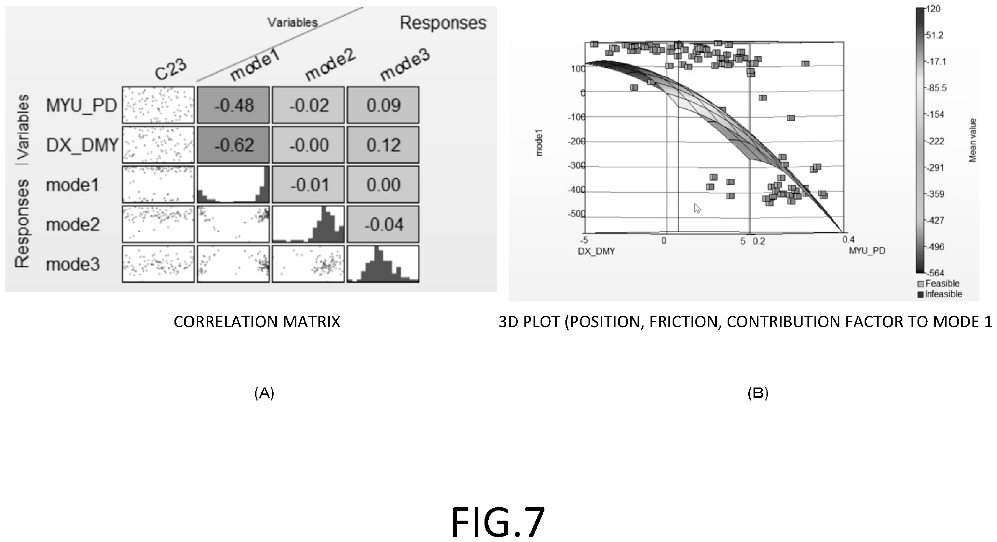

FIGS. 7(A) and 7(B) show a correlation matrix between input parameters and mode contribution ratios. From FIGS. 7(A) and 7(B), it can be seen that the position (DX_DMY) and friction (MU_PD) each have a strong correlation only with the first mode.

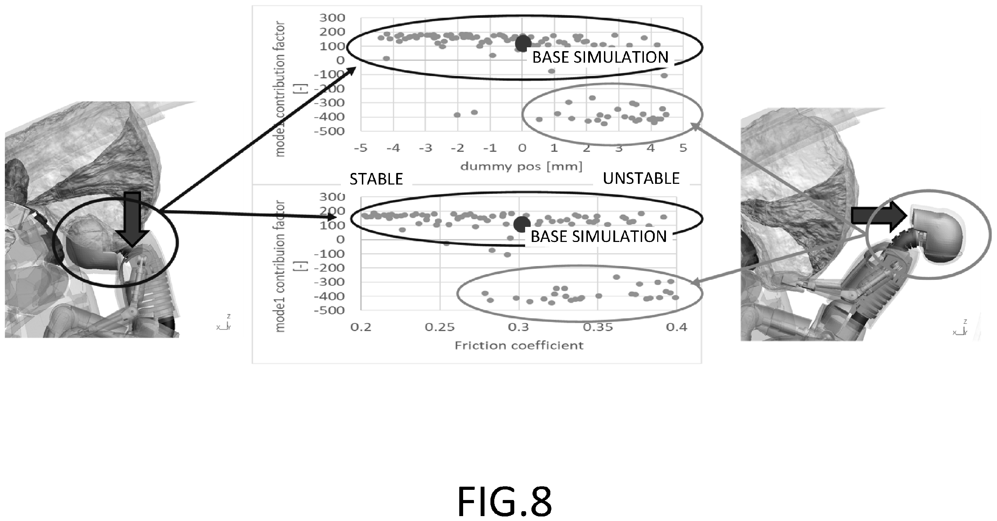

The influence that the dummy's position (input variation in this example) and the friction coefficient between the dummy and the airbag have on the coordinates in the mode space was obtained by sensitivity analysis through regression. The regression analysis results indicated that when the dummy's position is low, or when the friction coefficient is low, the mode on the left side in FIG. 8 stably occurs; however, if it moves even slightly above the baseline (zero point) or if the friction coefficient increases from the initial 0.3, the mode on the right side begins to appear, and the results start to bifurcate. The fact that a mode bifurcates indicates that the uncertainty of the outcome during use increases. This means that the design costs to accommodate that bifurcation increase, so it is necessary to review the design to stabilize the behavior.

In this way, the relationship between the main behavior modes and the input parameters that influence them can be visualized. With this approach, differences in results expressed in intuitive terms (such as head behavior) can be quantified for evaluation and study.

Next, the coefficient calculation unit 15 compares the set of test result curves of the base test (representing changes at predetermined locations of the vehicle obtained by the crash test) with the set of simulation curves from the base calculation, and calculates a coefficient such that the set of simulation curves from the base calculation fits the set of test result curves from the base test (FIG. 4: S6) .

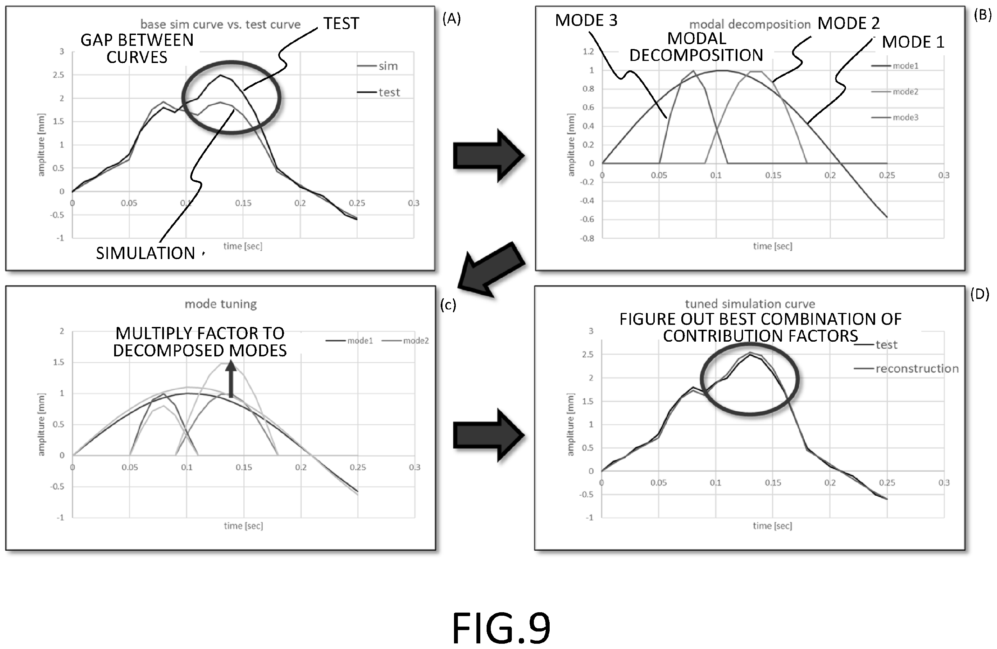

As shown in FIG. 9(A), there is a difference between a simulation curve obtained by the simulation and the test result curve. Therefore, the mode-decomposition unit 13 decomposes the simulation curve as shown in FIG. 9(B). Then, as shown in FIG. 9(C), the coefficient calculation unit 15 multiplies the decomposed modes by coefficients and sums them, adjusting the modes such that the simulation curve from the simulation is made to fit the test result curve.

Next, the reconstruction unit 17, based on the coefficients calculated as described above, reconstructs the set of simulation curves and based on the calculated coefficients, reconstructs virtual simulation results (shape and behavior data) predicted to have occurred in the base test (FIG. 4: S6).

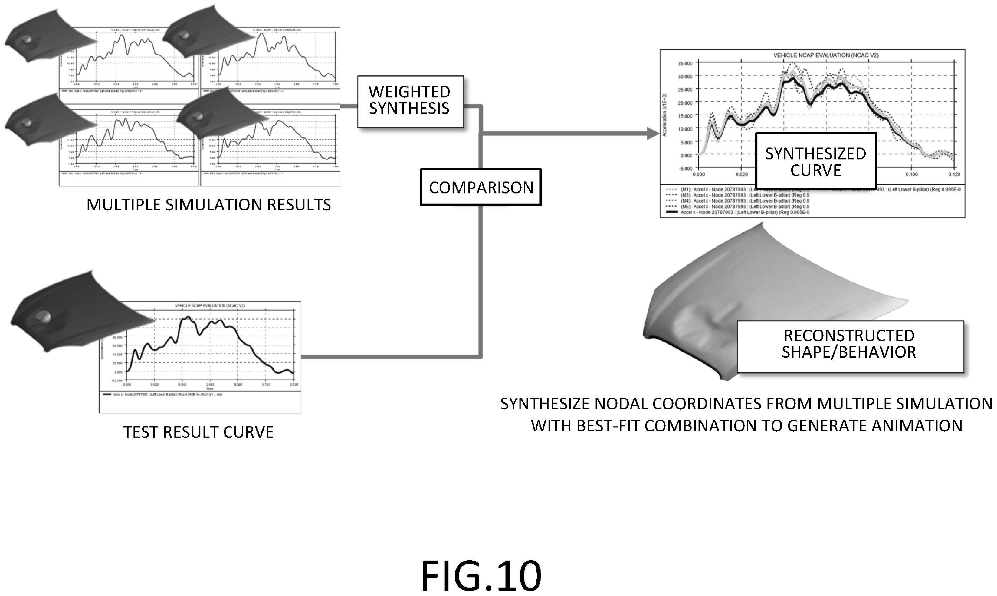

The reconstruction is performed by taking the mode vectors that were once decomposed and multiplying them by the coefficients obtained via optimization calculations and summing them. One example of this uses a reconstruction technique from SIDACT GmbH (Reference: European Patent No. 2924585) as shown in FIG. 10. This allows reconstruction of the vehicle's behavior (as shape and behavior data) that cannot be fully measured in the test.

Next, the force output unit 19 compares the shape and behavior data from the base calculation with the reconstructed virtual simulation results corresponding to the base test, and calculates the force required to correct errors. (FIG. 4: S7). The force output unit 19 also compares the shape and behavior data obtained from the calculation with the reconstructed virtual simulation results corresponding to the test as described above, and calculates the force required to correct errors. (FIG. 4: S7).

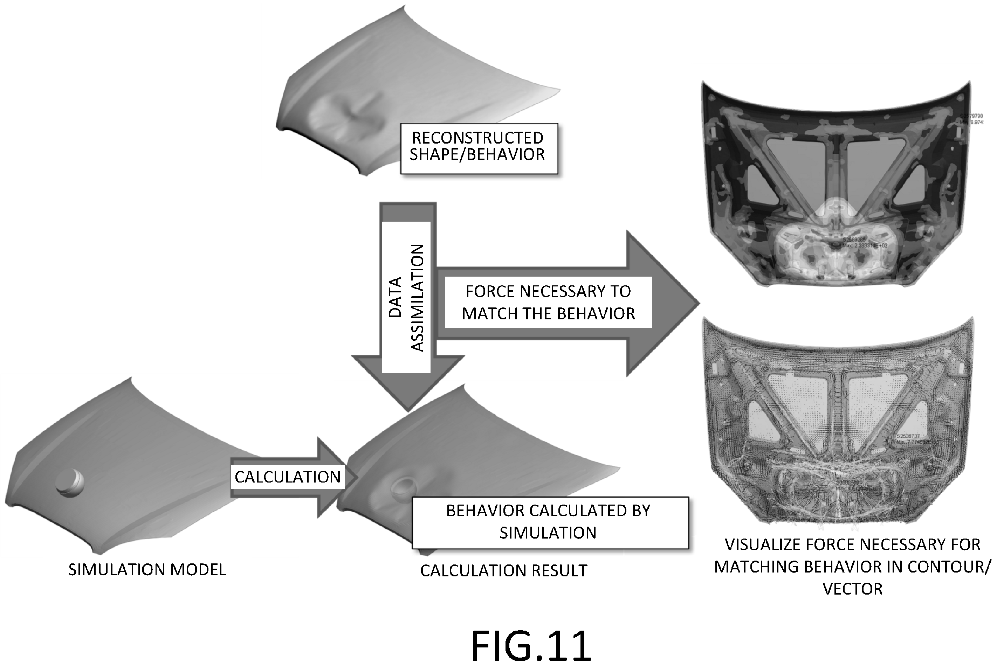

This force output processing is performed by calculating, and visualizing as a contour, the force required to fill the difference in behavior between the reconstructed virtual data corresponding to the base test and the base calculation's shape and behavior data (FIG. 11). One example considers applying the "Gray-Box-Processing" technique from Fraunhofer EMI (Reference 1: "'Grey-Box-Processing': a novel validation method for use in vehicle safety applications," Thomas Soot et al., published 18 April 2022, Volume 39, pp. 2677-2698 (2023); Reference 2: Japanese Publication No. 2023-524694). The Gray-Box-Processing technique uses data assimilation to calculate the force required to fill the behavioral gap between test and simulation and visualizes it as a contour. In the present embodiment, by applying this technique, the force required to fill the gap between the reconstructed virtual data corresponding to the base test and the base calculation's shape and behavior data is calculated and visualized as a contour. By performing such processing, it becomes possible to provide the user with hints of countermeasures needed to bring the simulation results closer to the test results, in areas where the simulation results deviate from the test results.

### <Function for Proposing Countermeasures to Correct Discrepancies of Simulation Results>

Next, the function for proposing countermeasures to correct the discrepancy of the simulation results relative to the test results in the present embodiment will be described with reference to FIG. 4 and FIG. 12 to FIG. 15. In the present embodiment, as shown in FIG. 4, by referring to past data stored in the knowledge database 122 (FIG. 4: S9), cases with high similarity in the differences between the current test result and simulation result are extracted, and further the countermeasures in those cases are extracted (FIG. 4: S10).

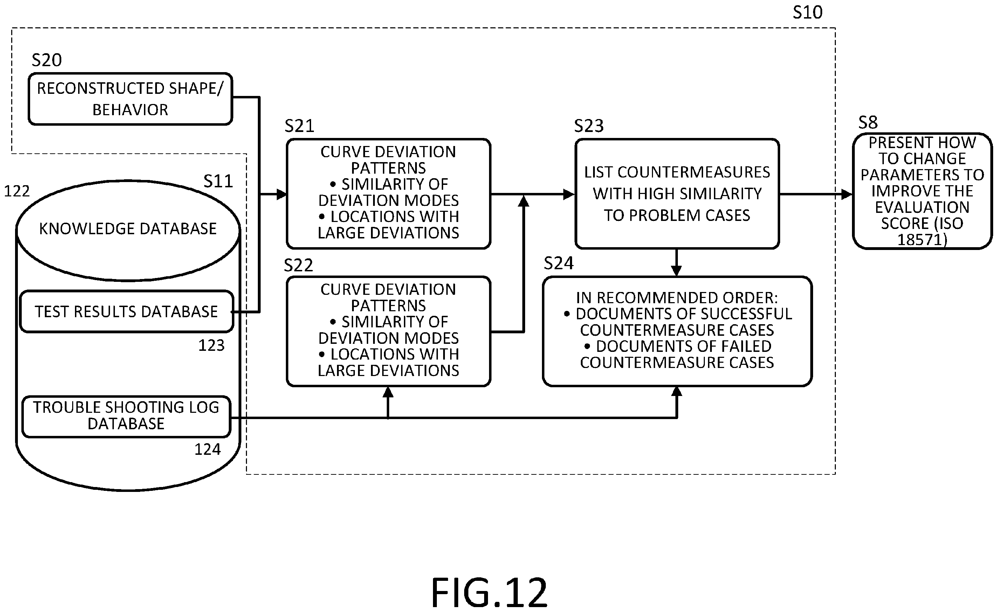

Details of step S10 in FIG. 4 are shown in FIG. 12. First, the discrepancy-pattern similarity determination unit 21 judges the similarity of the curve discrepancy-pattern based on the difference-pattern vector extracted in step S5 of FIG. 4 (FIG. 12: S21).

To judge the similarity of the curve discrepancy-pattern in this way, as shown in FIG. 13, the discrepancy-patterns between the test and the simulation are quantified, and it is determined whether the discrepancy-pattern in the current calculation (FIG. 12: S20) is similar to a discrepancy-pattern stored in the test result database 123 of the knowledge database 122. Specifically, the discrepancy-pattern is extracted as a difference-pattern vector, and the similarity is evaluated by comparing (for example, taking an inner product) the difference-pattern vector with another difference-pattern vector extracted from the same location in past data. This approach is based on the idea that if the way the results diverge in the same output channel is similar, the causes of that discrepancy are also likely to be similar.

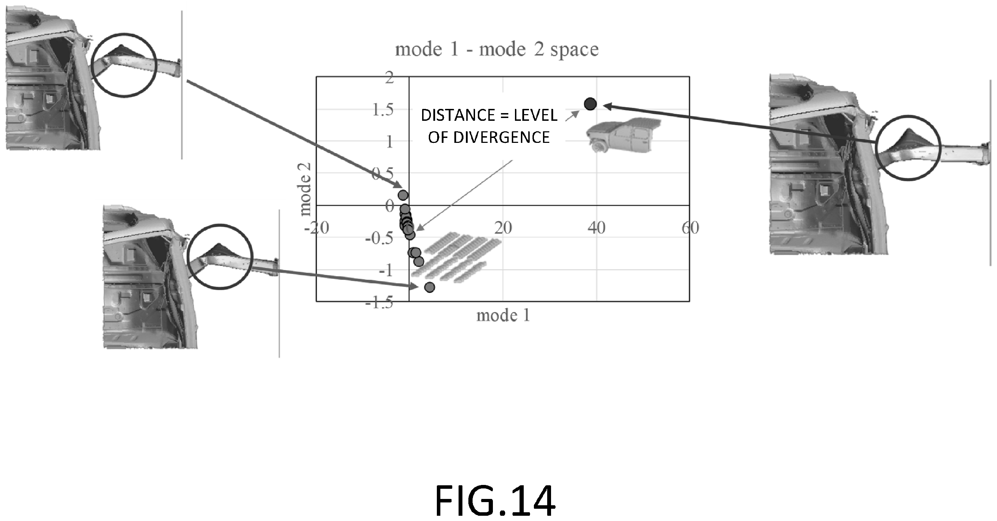

Next, the deformation-mode similarity determination unit 22, based on the current calculation (FIG. 12: S20) and data from the test result database 123 in the knowledge database 122, vectorizes the information of the set of nodal coordinates in mode space of the shape and behavior data from the simulation. Then, as shown in FIG. 14, by performing mode-decomposition on that vector, it calculates the distance in the mode space. In this way, the deformation-mode similarity determination unit 22 determines the similarity of deformation-modes by checking whether the mode coordinate values are close at a given timing (FIG. 12: S21). This approach is based on the idea that if the mode coordinate values at the same timing are close, the behaviors are also close.

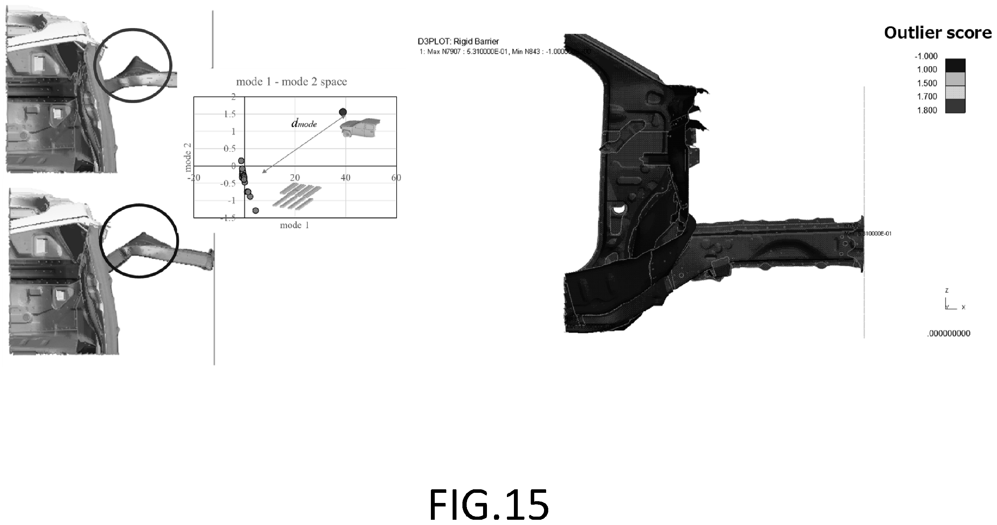

Next, the discrepancy-visualization unit 23, based on the current calculation (FIG. 12: S20) and data from the test result database 123 in the knowledge database 122, vectorizes the information of the set of nodal coordinates in mode space of the shape and behavior data from the simulation for a given component. Then, as shown in FIG. 15, by performing mode-decomposition on that vector, it calculates the distance or direction in the mode space. In other words, the concept of vectorizing information of the set of nodal coordinates in the shape of a finite element analysis result can be applied not only to the entire product (e.g., considering the entire automobile body as one entity), but also partially (e.g., focusing only on a certain component or assembly such as a bumper). Even if the overall behavior of the vehicle body appears similar when considered as a whole, a certain part might behave differently. In such cases, evaluating only the whole may overlook local differences. However, by evaluating on a part-by-part basis, such oversights can be prevented. In this way, the discrepancy-visualization unit 23 determines whether the mode coordinate values are close at a given timing and visualizes as a contour the discrepancy of the behavior of the given component (FIG. 12: S21). By increasing the granularity of evaluation in this way, it becomes possible to perform similarity searches such as identifying that the behavior of a certain component is similar in different cases. Note that the method of visualizing the discrepancy, as described above, is not limited to using contours. Methods for expressing discrepancy can include representing it as scalar or vector values. For example, a method may be employed in which scalar values are indicated by a color bar (for instance, blue for low values and red for high values). It is also conceivable to present vector values using arrows.

After the searches for curve discrepancy-patterns, deformation-mode similarity, and highly divergent components are completed as described above (FIG. 12: S21), a comparison with past problem cases in the trouble-shooting log database 124 of the knowledge database 122 is performed based on the discrepancy-patterns, deformation-mode similarity, and highly divergent components (FIG. 12: S22). Specifically, among the information on past curve discrepancy-patterns, deformation-mode similarity, and highly divergent components in trouble-shooting log database 124, information that is close to the results obtained in step S21 is searched.

Then, the recommendation proposal unit 24, based on at least one output of the discrepancy-pattern similarity determination unit 21, the deformation-mode similarity determination unit 22, and the discrepancy-visualization unit 23, extracts and lists countermeasures for cases with a high similarity in differences between the current test result and simulation result, based on data in the trouble-shooting log database 124 of the knowledge database 122 (FIG. 12: S23). For example, the trouble-shooting log database may store reports of countermeasures taken in the past linked with the difference-pattern vectors at that time, and a pattern recognition AI trained to judge when a stored pattern is similar to the current pattern can be combined with a summary AI and proposal AI that, when a pattern is judged similar, summarize and present to the user the report linked to that pattern. Also, the recommendation proposal unit 24 outputs, in order of effectiveness, documents of successful countermeasure cases and documents of failed countermeasure cases, based on past reports and comments stored in trouble-shooting log database 124 (FIG. 12: S24).

Then, the recommendation proposal unit 24, based on the correlation of parameters calculated in step S6 of FIG. 4, and on the documents of successful and failed countermeasure cases, proposes a list of candidate ways to change the parameters to increase the predetermined evaluation score (ISO 18571) (FIG. 4, FIG. 12: S8).

In this way, according to the present embodiment, a candidate list of how to change parameters to increase the predetermined evaluation score (ISO 18571) is proposed to the user. Therefore, the user can easily identify the locations or parameters causing the discrepancy between the test results and simulation results and can improve the accuracy of the simulation model while utilizing past test and simulation result data.

The user then, based on the proposals described above, makes changes and feeds back the results or reports (such as whether the discrepancy between the test result and simulation result was reduced or not) to the simulation database 121 and the knowledge database 122 (FIG. 4: S11, S12). By doing so, more data are accumulated, and the accuracy of the simulation model can be further improved.

### (Second Embodiment)

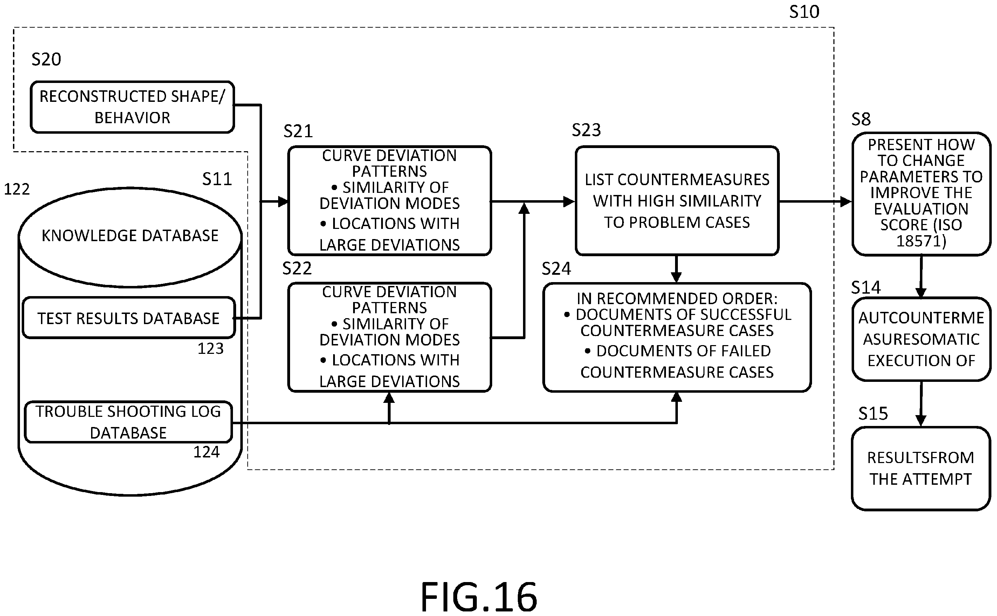

Next, a second embodiment of the present invention will be described with reference to FIG. 16.

In the first embodiment, the recommendation proposal unit 24 proposed a list of candidate changes to parameters to increase the score in ISO 18571, and the user was the one who made decisions and carried them out.

However, in the present embodiment, an automatic execution unit is provided, and as shown in FIG. 16, the execution of the proposed countermeasure is automatically carried out by the automatic execution unit (FIG. 16: S14). The automatic execution unit then presents the obtained results to the user (FIG. 16: S15). In this case, the user makes the judgment on the results.

As described above, according to the present embodiment, not only is a candidate list of how to change parameters to increase the predetermined evaluation score (CORA) proposed, but the execution of the countermeasure is also automatically performed by the automatic execution unit. Therefore, the user can even more easily identify the locations or parameters causing the discrepancy between test results and simulation results and can improve the accuracy of the simulation model while utilizing past test and simulation result data.

### (Modified Example)

The above embodiments are illustrative, and various modifications are possible without departing from the scope of the invention. In the embodiments described above, an example using one base test and one base calculation was explained, but the present invention is not limited to such an example. For instance, a second base test with different velocity and angle conditions than the first base test, and a second base calculation corresponding to this second base test, may be added (FIG. 4: S1, S2). Such information may be obtained from the simulation unit or other components, or from past data in the simulation database unit as needed. Furthermore, multiple variation-case simulations with changed velocity and angle conditions may be added for simulation and mode-decomposition (FIG. 4: S3).

In the embodiments described above, the correlation calculation unit 14 was described as an essential component, but the present invention is not limited to such an aspect. It would be possible to configure the simulation model accuracy-improvement support system 100 described above without the correlation calculation unit 14. However, including the correlation calculation unit 14 is preferable because it improves the persuasiveness and accuracy of the proposals described above.

In the embodiments described above, examples were given in which the mode-decomposition unit 13, the correlation calculation unit 14, the coefficient calculation unit 15, and the reconstruction unit 17 apply SIDACT's technology, but the present invention is not limited to such an aspect. Any technology may be used as long as the functions of each of the above units are realized, it is not required to use SIDACT's technology.

In the embodiments described above, the force output unit 19 was described using Fraunhofer's technology to compare the base calculation's shape and behavior data with the reconstructed virtual shape and behavior data corresponding to the base test and calculate the force which is necessary to correct errors. However, the present invention is not limited to such an aspect. For example, after sufficient data have been accumulated, an estimation of the required force may be performed by searching the knowledge database 122 using the discrepancy-pattern in the mode space as a key. This is because if the patterns of discrepancy differ, the patterns of insufficient or excessive force are also likely to be similar, making it possible to map that information to the target shape. Additionally, as another example of force output, one could cite a simple method of calculating the required force using Newtonian mechanics F = m * a from the differences in the positions of the centers of gravity of components in each calculation and their masses.

In the embodiments described above, an example was described in which the similarity determination unit is provided with the discrepancy-pattern similarity determination unit 21 and the deformation-mode similarity determination unit 22. However, the present invention is not limited to such an aspect. The similarity determination unit may be configured with only one of the discrepancy-pattern similarity determination unit 21 or the deformation-mode similarity determination unit 22. Also, the threshold values or weightings used when judging similarity of past cases based on shape or curve discrepancy-patterns can be made adjustable by a system administrator or the user as needed. Furthermore, the similarity-determination may be based on strict logic, or it may be heuristic, including approaches such as deep learning.

In the embodiments described above, an example was described in which both the discrepancy-visualization unit 23 and the recommendation proposal unit 24 are provided. However, the present invention is not limited to such an aspect. If at least the recommendation proposal unit 24 is provided as described above, the user can improve the accuracy of the simulation model based on the proposals by the recommendation proposal unit 24. However, if the discrepancy-visualization unit 23 is provided, after seeing the proposals from the recommendation proposal unit 24, the user can verify their validity by checking the information from the discrepancy-visualization unit 23. Alternatively, depending on the user, it may be possible to solve the problem with only the information visualized by the discrepancy-visualization unit 23. Moreover, during each of the above processes, it can be arranged that the results that emerge at each process can be visually confirmed by the user upon request. Furthermore, it can be arranged that each of the above processes can be interrupted midway to allow the user to perform recalculations or changes of input data, based on the user's judgment.

In the embodiments described above, as one example, an embodiment was described in which a finite element simulation is used for evaluating vehicle crash safety. However, the present invention is not limited to such an application. For example, it can be applied to any evaluation performed via simulation, such as material property evaluation, structural evaluation, seismic evaluation, electromagnetic characteristic evaluation, and so on.

Also, in the embodiments described above, a vehicle was used as a physical object and virtual object, but the present invention is not limited to this. An airplane, a ship, or a train can be used as a physical object and virtual object.

The simulation model accuracy-improvement support program according to the above aspects can be provided in the form of being stored on a computer-readable recording medium and installed on a computer. The recording medium is, for example, a non-transitory recording medium such as CD-ROM or similar optical recording medium being a representative example-but can encompass any known form of recording medium such as a semiconductor memory or a magnetic recording medium. It is also possible to provide the program described above in the form of distribution via a communication network to be installed on a computer.

As described above, while the simulation model accuracy-improvement support system, simulation model accuracy-improvement support method, and simulation model accuracy-improvement support program according to embodiments of the present invention have been explained, the present invention is not limited to these, and various changes can be made without departing from the spirit of the invention.

### EXPLANATION OF REFERENCE SIGNS

10 control unit
11 test result data input unit
12 simulation unit
13 mode-decomposition unit
14 correlation calculation unit
15 coefficient calculation unit
16 difference-pattern vector extraction unit
17 reconstruction unit
19 force output unit
20 server registration unit
21 discrepancy-pattern similarity determination unit
22 deformation-mode similarity determination unit
23 discrepancy-visualization unit
24 recommendation proposal unit
100 simulation model accuracy-improvement support system
110 simulation model accuracy-improvement support device
121 simulation database
122 knowledge database
123 test result database
124 trouble-shooting log database

## Claims

1. A simulation model accuracy-improvement support system, comprising:
a test result data input unit configured to input test result data obtained from a crash test involving a physical object such as a vehicle;
a simulation unit configured to perform, using CAE analysis software based on a finite element method, a simulation of the crash test for a virtual object corresponding to the physical object;
a mode-decomposition unit configured to perform mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
a coefficient calculation unit configured to compare the set of simulation curves with a set of test result curves included in the test result data, the set of test result curves representing changes at predetermined locations of the physical object obtained from the crash test including acceleration outputs or displacement outputs, and to calculate coefficients for fitting the set of simulation curves to the set of test result curves;
a reconstruction unit configured to reconstruct the set of simulation curves based on the calculated coefficients and to reconstruct virtual shape and behavior data predicted to have occurred in the crash test based on the calculated coefficients; and
a force output unit configured to compare the shape and behavior data generated by the simulation unit with the reconstructed shape and behavior data reconstructed by the reconstruction unit and to calculate or estimate forces required to correct differences between them.

2. The simulation model accuracy-improvement support system according to claim 1, further comprising a correlation calculation unit that calculates a correlation between the mode-decomposed simulation curve group and shape and behavior data, and parameters of the virtual object including sheet metal thickness and the like.

3. A simulation model accuracy-improvement support system, comprising:
a test result data input unit configured to input test result data obtained from a crash test involving a physical object such as a vehicle;
a simulation unit configured to perform, using CAE analysis software based on a finite element method, a simulation of the crash test for a virtual object corresponding to the physical object;
a mode-decomposition unit configured to perform mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
a difference-pattern vector extraction unit configured to compare the set of simulation curves with a set of test result curves included in the test result data, the set of test result curves representing changes at predetermined locations of the physical object obtained from crash tests including acceleration outputs or displacement outputs, and extract a difference-pattern vector;
a coefficient calculation unit configured to compare the set of simulation curves with a set of test result curves, and to calculate coefficients for fitting the set of simulation curves to the set of test result curves;
a reconstruction unit configured to reconstruct the set of simulation curves based on the calculated coefficients and to reconstruct virtual shape and behavior data predicted to have occurred in the crash test based on the calculated coefficients;
a force output unit configured to compare the shape and behavior data generated by the simulation unit with the reconstructed shape and behavior data reconstructed by the reconstruction unit and to calculate or estimate forces required to correct differences between them;
a knowledge database unit configured to store data including past test results, past simulation results, past proposal reports, and information regarding differences between past test results and simulations;
a similarity determination unit configured to determine similarity regarding differences between the current test result and the simulation based on the test result data, the shape and behavior data generated by the simulation unit, the reconstructed shape and behavior data reconstructed by the reconstruction unit, or data from the knowledge database unit; and
a recommendation proposal unit configured to extract, based on an output of the similarity determination unit, countermeasures corresponding to cases having high similarity regarding differences between the current test result and the simulation from the data in the knowledge database and to propose how parameters of the virtual object including sheet metal thickness should be changed in order to improve a predetermined evaluation score.

4. The simulation model accuracy-improvement support system according to claim 3, further comprising a discrepancy-visualization unit is configured, based on the shape and behavior data created by the simulation unit and the shape and behavior data reconstructed by the reconstruction unit, to vectorize information of a nodal coordinate group in mode space of a given component in the shape and behavior data, and to calculate a distance or direction in the mode space by performing mode-decomposition on the vector, thereby visualizing the degree of discrepancy of the shape and behavior of the given component from the direction of the difference-pattern vector at a given timing, based on whether mode coordinate values are close or not,
wherein the recommendation proposal unit is configured, based on output from at least one of the similarity determination unit and the discrepancy-visualization unit, to extract from the data of the knowledge database, a countermeasure for a case having a high similarity in differences between the current test result and simulation result, and proposes how the parameters should be changed in order to improve a predetermined evaluation score.

5. The simulation model accuracy-improvement support system according to claim 4,
wherein the similarity determination unit comprises:
a discrepancy-pattern similarity determination unit configured to determine similarity of curve discrepancy-patterns based on the difference pattern vector; and
a deformation-mode similarity determination unit configured to vectorize, based on the shape and behavior data generated by the simulation unit and the shape and behavior data reconstructed by the reconstruction unit, information of nodal coordinate groups in a mode space of the shape and behavior data, and to calculate a distance or direction in the mode space by decomposing the vector into modes, and to determine similarity of deformation-modes based on whether mode coordinate values are close at a predetermined timing,
wherein the recommendation proposal unit is configured to extract, based on outputs of at least one of the discrepancy-pattern similarity determination unit, the deformation-mode similarity determination unit, and a discrepancy-visualization unit, countermeasures corresponding to cases having high similarity regarding differences between a current test result and a simulation from data stored in the knowledge database, and proposes how the parameters should be changed in order to improve a predetermined evaluation score.

6. The simulation model accuracy-improvement support system according to any one of claims 3 to 5, further comprising a correlation calculation unit that calculates a correlation between the mode-decomposed simulation curve group and shape and behavior data, and parameters of the virtual object including sheet metal thickness and the like.

7. The simulation model accuracy-improvement support system according to any one of claims 3 to 5, further comprising an automatic execution unit that automatically executes the countermeasure proposed by the recommendation proposal unit.

8. The simulation model accuracy-improvement support system according to claim 6, further comprising an automatic execution unit that automatically executes the countermeasure proposed by the recommendation proposal unit.

9. A computer-implemented method for supporting simulation model accuracy-improvement comprising the steps of:
inputting test result data obtained from a crash test involving a physical object such as a vehicle by a test result data input unit;
performing, by a simulation unit, a simulation of the crash test for a virtual object corresponding to the physical object using CAE analysis software based on a finite element method;
performing mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
comparing, by a coefficient calculation unit, the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing, by a reconstruction unit, the set of simulation curves based on the calculated coefficients, and reconstructing virtual shape and behavior data predicted to have occurred in the crash test based on the calculated coefficients; and
comparing, by a force output unit, the shape and behavior data generated by the simulation unit with the reconstructed shape and behavior data reconstructed by the reconstruction unit, and calculating or estimating forces required to correct differences between them.

10. The simulation model accuracy-improvement support method according to claim 9, further comprising a step of calculating, by a correlation calculation unit, a correlation between the mode-decomposed simulation curve group and shape and behavior data, and parameters of the virtual object including sheet metal thickness and the like.

11. A computer-implemented method for supporting simulation model accuracy-improvement comprising the steps of:
inputting test result data obtained from a crash test involving a physical object such as a vehicle by a test result data input unit;
performing, by a simulation unit, a simulation of the crash test for a virtual object corresponding to the physical object using CAE analysis software based on a finite element method;
performing mode-decomposition on shape and behavior data and a set of simulation curves generated by the simulation unit, that is, the shape and behavior data representing the shape and behavior of the virtual object and the set of simulation curves representing changes at predetermined locations of the virtual object including acceleration outputs or displacement outputs;
comparing, by a difference-pattern vector extraction unit, the set of simulation curves with a set of test result curves included in the test result data, the set of test result curves representing changes at predetermined locations of the physical object obtained from crash tests including acceleration outputs or displacement outputs, and extracting a difference-pattern vector;
comparing, by a coefficient calculation unit, the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing, by a reconstruction unit, the set of simulation curves based on the calculated coefficients, and reconstructing virtual shape and behavior data predicted to have occurred in the crash test based on the calculated coefficients;
comparing, by a force output unit, the shape and behavior data generated by the simulation unit with the reconstructed shape and behavior data reconstructed by the reconstruction unit, and calculating or estimating forces required to correct differences between them;
determining, by a similarity determination unit, similarity regarding differences between the current test result and the simulation based on the test result data, the shape and behavior data generated by the simulation unit, the reconstructed shape and behavior data reconstructed by the reconstruction unit, or data obtained from a knowledge database unit storing data including past test results, past simulation results, past proposal reports, and information regarding differences between past test results and simulations; and
extracting, by a recommendation proposal unit, based on an output of the similarity determination unit, countermeasures corresponding to cases having high similarity regarding differences between the current test result and the simulation from the data stored in the knowledge database unit, and proposing how parameters of the virtual object including sheet metal thickness should be changed in order to improve a predetermined evaluation score.

12. The computer-implemented method according to claim 11, further comprising a step of vectorizing, by a discrepancy-visualization unit, based on the shape and behavior data created by the simulation unit and the shape and behavior data reconstructed by the reconstruction unit, information of a nodal coordinate group in mode space of a given component in the shape and behavior data, and calculating a distance or direction in the mode space by performing mode-decomposition on the vector, thereby visualizing the degree of discrepancy of the shape and behavior of the given component from the direction of the difference-pattern vector at a given timing, based on whether mode coordinate values are close or not,
wherein the step of proposing extracts, based on an output of at least one of the similarity determination unit and the discrepancy-visualization unit, from the data of the knowledge database, a countermeasure for a case having a high similarity in differences between the current test result and simulation, and proposes how the parameters should be changed in order to improve a predetermined evaluation score.

13. The computer-implemented method according to claim 12,
wherein the step of determining the similarity comprises the steps of:
determining, by a discrepancy-pattern similarity determination unit included in the similarity determination unit, similarity of curve discrepancy-patterns based on the difference-pattern vector; and
vectorizing, by a deformation-mode similarity determination unit included in the similarity determination unit, based on the shape and behavior data generated by the simulation unit and the shape and behavior data reconstructed by the reconstruction unit, information of nodal coordinate groups in a mode space of the shape and behavior data, and calculating a distance or direction in the mode space by decomposing the vector into modes, and determining similarity of deformation-modes based on whether mode coordinate values are close at a predetermined timing,
wherein the step of proposing extracts, based on outputs of at least one of the discrepancy-pattern similarity determination unit, the deformation-mode similarity determination unit, and the discrepancy-visualization unit, from data of the knowledge database, a countermeasure for a case having high a similarity regarding differences between the current test result and simulation and proposes how the parameters should be changed in order to improve a predetermined evaluation score.

14. The computer-implemented method according to any one of claims 11 to 13, further comprising a step of calculating, by a correlation calculation unit, a correlation between the mode-decomposed simulation curve group and shape and behavior data, and parameters of the virtual object including sheet metal thickness and the like.

15. The computer-implemented method according to any one of claims 11 to 13, further comprising a step of automatically executing, by an automatic execution unit, the countermeasure proposed by the recommendation proposal unit.

16. The simulation model accuracy-improvement support method according to claim 14, further comprising a step of automatically executing, by an automatic execution unit, the countermeasure proposed by the recommendation proposal unit.

17. A computer program for supporting simulation model accuracy-improvement, the computer program causing a computer to perform the steps of:
inputting test result data obtained from a crash test involving a physical object such as a vehicle;
performing a simulation of the crash test for a virtual object corresponding to the physical object using CAE analysis software based on a finite element method;
performing mode-decomposition on shape and behavior data and a set of simulation curves generated by the step of simulation, that is, the shape and behavior data representing the shape and behavior of the virtual object and the set of simulation curves representing changes at predetermined locations of the virtual object including acceleration outputs or displacement outputs;
comparing the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing the set of simulation curves based on the calculated coefficients, and reconstructing virtual shape and behavior data predicted to have occurred in the crash test based on the calculated coefficients; and
comparing the shape and behavior data generated by the simulation with the reconstructed shape and behavior data reconstructed, and calculating or estimating forces required to correct differences between them.

18. The program according to claims 17, the computer program causing the computer to perform a step of calculating a correlation between the mode-decomposed simulation curve group and shape and behavior data, and parameters of the virtual object including sheet metal thickness and the like.

19. A computer program for supporting simulation model accuracy-improvement, the computer program causing a computer to perform the steps of:
inputting test result data obtained from a crash test involving a physical object such as a vehicle;
performing a simulation of the crash test for a virtual object corresponding to the physical object using CAE analysis software based on a finite element method;
performing mode-decomposition on shape and behavior data and a set of simulation curves, that is, the shape and behavior data representing the shape and behavior of the virtual object and the set of simulation curves representing changes at predetermined locations of the virtual object including acceleration outputs or displacement outputs;
comparing the set of simulation curves with a set of test result curves included in the test result data, the set of test result curves representing changes at predetermined locations of the physical object obtained from crash tests including acceleration outputs or displacement outputs, and extracting a difference-pattern vector;
comparing the set of simulation curves with a set of test result curves included in the test result data, the set of test result curves representing changes at predetermined locations of the physical object obtained from the crash test including acceleration outputs or displacement outputs, and calculating coefficients for fitting the set of simulation curves to the set of test result curves;
reconstructing the set of simulation curves based on the calculated coefficients, and reconstructing virtual shape and behavior data predicted to have occurred in the crash test based on the calculated coefficients;
comparing the shape and behavior data generated by the step of performing the simulation with the reconstructed shape and behavior data reconstructed, and calculating or estimating forces required to correct differences between them;
determining similarity regarding differences between the current test result and the simulation based on the test result data, the shape and behavior data generated by the step of performing the simulation, the reconstructed shape and behavior data reconstructed by the step of reconstructing, or data obtained from a knowledge database storing data including past test results, past simulation results, past proposal reports, and information regarding differences between past test results and simulations; and
extracting, based on an output of the step of determining the similarity, countermeasures corresponding to cases having high similarity regarding differences between the current test result and the simulation from the data stored in the knowledge database, and proposing how parameters of the virtual object including sheet metal thickness should be changed in order to improve a predetermined evaluation score.

20. The program according to claim 19, the program causing the computer to perform a step of vectorizing, based on the shape and behavior data created by the step of performing the simulation and the shape and behavior data reconstructed by the step of reconstructing, information of a nodal coordinate group in mode space of a given component in the shape and behavior data, and calculating a distance or direction in the mode space by performing mode-decomposition on the vector, thereby visualizing the degree of discrepancy of the shape and behavior of the given component from the direction of the difference-pattern vector at a given timing, based on whether mode coordinate values are close or not,
as the step of proposing, extracting, based on an output of at least one of the step of determining the similarity and the step of visualizing the degree of discrepancy, from the data of the knowledge database, a countermeasure for a case having a high similarity in differences between the current test result and simulation result, and proposing how the parameters should be changed in order to improve a predetermined evaluation score.

21. The program according to claim 20, the program causing the computer to perform the steps of; as the step of determining the similarity, determining similarity of curve discrepancy-patterns based on the difference-pattern vector; and
vectorizing, based on the shape and behavior data generated by the step of performing the simulation and the shape and behavior data reconstructed by the step of reconstructing, information of nodal coordinate groups in a mode space of the shape and behavior data, and calculating a distance or direction in the mode space by decomposing the vector into modes, and determining similarity of deformation-modes based on whether mode coordinate values are close at a predetermined timing,
as the step of proposing, extracting, based on outputs of at least one of the step of determining similarity of the discrepancy-pattern, the step of determining the similarity of the deformation-mode, and the step of visualizing the degree of the discrepancy, from the data of the knowledge database, a countermeasure for a case having a high similarity regarding differences between the current test result and simulation, and proposing how the parameters should be changed in order to improve a predetermined evaluation score.

22. The program according to any one of claims 19 to 21, the program causing the computer to perform the step of calculating a correlation between the mode-decomposed simulation curve group and shape and behavior data, and parameters of the virtual object including sheet metal thickness and the like.

23. The program according to any one of Claims 19 to 21, the program causing the computer to perform the step of automatically executing the countermeasure proposed by the step of proposing.

24. The program according to claim 22, the program causing the computer to perform the step of automatically executing the countermeasure proposed by the step of proposing.
